# EUROPEAN PATENT APPLICATION

(11) **EP 4 742 230 A1**
(43) Date of publication of application: **13.05.2026**
(21) Application number: 25205695.7
(22) Date of filing: 30.09.2025
(51) Int. Cl.: G09G 3/3233, H10D 30/67, H10D 86/40, H10D 86/60, H10K 59/121, H10D 62/80

(54) **TRANSISTOR AND DISPLAY DEVICE INCLUDING THE SAME**

(30) Priority: 12.11.2024 KR 20240160311
(71) Applicant: LG Display Co., Ltd., Seoul 150-721 (KR)
(72) Inventor: IM, Seo Yeon, Paju-si, Gyeonggi-do (KR)
(74) Representative: Viering, Jentschura & Partner mbB Patent- und Rechtsanwälte

(57) **Abstract**

A display device includes a substrate (111) including a first area (AAl) including first subpixels (SP1) and a transmissive part (TA), and a second area (AA") including second subpixels (SP2). A first transistor (T1) in the first area (A1) includes an oxide semiconductor active layer (ACT1), a gate electrode (G1), and first and second source-drain electrodes (SD11, SD12). A second transistor (T2) disposed in the first area (AA1) includes an oxide semiconductor active layer (ACT2) including first and second active layers (A21, A22), a gate electrode (G2), and first and second source-drain electrodes (SD21, SD22). A light-emitting element (135) is disposed in the first area (AA1). A third transistor (T3) is connected between the second transistor (T2) and the light-emitting element (135) and includes an oxide semiconductor active layer (ACT3) including first and second active layers (A31, A32), a gate electrode (G3), and first and second source-drain electrodes (SD31, SD32). The second active layer (A32) of the third transistor (T3) has a higher carrier mobility than the first active layer (A31) of the third transistor (T3).

## Description

### BACKGROUND

### Field of the Disclosure

The present disclosure relates to a transistor and a display device including the same.

### Discussion of the Related Art

Display devices configured to display images in TVs, monitors, smartphones, tablets, laptops, etc. use various systems and forms. Among display devices, a light-emitting display device having light-emitting elements in a display panel without a separate light source is considered as a competitive application for compactness and sharp color representation.

Display devices commonly employ transistors to perform various different functions. For example, a display device can include an active area having a plurality of pixels to implement images are equipped with transistors configured to control pixel operation on a pixel basis. In contrast, in a non-active area surrounding the plurality of pixels, the display device can include transistors serving other functions, such as providing data and control signals to the plurality of pixels.

However, transistors used for different functions can require different characteristics and, as such, structural differences of between various transistors are necessary. On the other hand, it is advantageous to form all of the various transistors by the same processes to reduce processing steps. Accordingly, display devices having transistors with structural differences but made by the same process are desirable.

### SUMMARY OF THE DISCLOSURE

Accordingly, the present disclosure is directed to a transistor and a display device including the same substantially obviate one or more problems due to limitations and disadvantages of the related art. An object according to various embodiments of the present disclosure is to provide a transistor capable of reducing occurrence of a hot carrier stress phenomenon, and a display device including the transistor. Another object according to various embodiments of the present disclosure is to provide a transistor capable of increasing the area of a transmissive part of a display area and enhancing transmittance, and a display device including the transistor.

Still another object according to various embodiments of the present disclosure is to provide a transistor capable of enhancing picture quality while providing high luminance, and a display device including the transistor. Yet another object according to various embodiments of the present disclosure is to differently set an S-factor and an on-current value in accordance with the function of a transistor.

Still further, yet another object is to provide a transistor which is advantageous, stable, and finely controllable for gradation representation, and a display device including the transistor. Furthermore, an additional object is to achieve environmental/social/governance (ESG) goals by enhancing reliability of a transistor and reducing power consumption of the transistor.

Objects of the present disclosure are not limited to the above-described objects, and other objects of the present disclosure not yet described will be more clearly understood by those skilled in the art from the following description. To achieve these objects and other advantages and in accordance with the purpose of the disclosure, as embodied and broadly described herein, there is provided a transistor according to claim 1. Further embodiments are described in the dependent claims. A transistor according to an embodiment of the present disclosure can include an active layer including a first active layer including an oxide semiconductor material and a second active layer having a higher carrier mobility than a carrier mobility of the first active layer, a gate electrode disposed to overlap with the active layer to form a channel region of the active layer, a first source-drain electrode insulated from the gate electrode and connected to the second active layer, and a second source-drain electrode insulated from the gate electrode and connected to the first active layer.

A transistor according to another embodiment of the present disclosure can comprise an active layer including a region where the second active layer and the gate electrode do not overlap each other. The first active layer and the second source-drain electrode can be connected to each other in the region where the second active layer and the gate electrode do not overlap each other. The second active layer and the first source-drain electrode can be connected to each other in a region where the first active layer and the gate electrode do not overlap each other. The channel region can include a first channel region where the gate electrode and the first active layer overlap each other, and a second channel region where the gate electrode and the second active layer overlap each other. The length of the second channel region can be greater than the length of the first channel region. In other embodiments, a transistor can comprise at least a portion of the first channel region not overlapping with at least a portion of the second active layer.

In another aspect of the present disclosure, a display device includes a substrate including a first area including a plurality of first subpixels and a transmissive part, and a second area including a plurality of second subpixels, a first transistor disposed in the first area with the transmissive part, the first transistor including an active layer including an oxide semiconductor material, a gate electrode, and a first source-drain electrode and a second source-drain electrode, and a second transistor disposed in the first area with the transmissive part, the second transistor including an active layer including a first active layer and a second active layer each including an oxide semiconductor material, a gate electrode, and a first source-drain electrode and a second source-drain electrode. The display device further includes a light-emitting element disposed in the first area with the transmissive part, and a third transistor electrically connected between the second transistor and the light-emitting element, the third transistor including an active layer including a first active layer and a second active layer each including an oxide semiconductor material, a gate electrode, and a first source-drain electrode and a second source-drain electrode. The second active layer of the third transistor has a higher carrier mobility than a carrier mobility of the first active layer of the third transistor.

The display device can further include a first capacitor electrode disposed beneath the second transistor under a condition where an insulating layer is interposed between the first capacitor electrode and the second transistor, and a second capacitor electrode disposed between the first capacitor electrode and the second transistor in a state of being insulated from the first capacitor electrode. The first capacitor electrode can be connected to the gate electrode of the second transistor, and the second capacitor electrode can be connected to the first source-drain electrode of the second transistor. Along with the above effects, the specific effects of the present disclosure will be described below, providing concrete matters for implementing the present disclosure.

### BRIEF DESCRIPTION OF THE DRAWINGS

The accompanying drawings, which are included to provide a further understanding of the disclosure and are incorporated in and constitute a part of this application, illustrate embodiment(s) of the disclosure and along with the description serve to explain the principle of the disclosure. In the drawings:
FIG. 1 is a schematic plan view of a display device according to embodiments of the present disclosure;
FIG. 2 is an enlarged plan view of a portion A of the display device in FIG. 1 according to an embodiment of the present disclosure;
FIG. 3 is an enlarged plan view of a portion P of the portion in FIG. 2 according to an embodiment of the present disclosure;
FIG. 4 is a circuit diagram for each first subpixel of the display device according to an embodiment of the present disclosure;
FIG. 5 is a circuit diagram of a first subpixel of a display device according to another embodiment of the present disclosure;
FIG. 6 is a cross-sectional view of transistors T2, T3, and T4 according to a first embodiment of the present disclosure;
FIG. 7 is a cross-sectional view of transistors T2, T3, and T4 according to a second embodiment of the present disclosure;
FIG. 8 is a cross-sectional view of transistors T2, T3, and T4 according to a third embodiment of the present disclosure;
FIG. 9 is a cross-sectional view of transistors T2, T3, and T4 according to a fourth embodiment of the present disclosure;
FIG. 10 is a cross-sectional view of transistors T2, T3, and T4 according to a fifth embodiment of the present disclosure;
FIG. 11 is a cross-sectional view of a first subpixel of a display device according to an embodiment of the present disclosure;
FIG. 12 is a cross-sectional view of a display device explaining transistors T4, T5, T6, and T7 of FIG. 5 according to an embodiment of the present disclosure; and
FIG. 13 is a cross-sectional view of a first subpixel of a display device according to another embodiment of the present disclosure.

### DETAILED DESCRIPTION OF THE EMBODIMENTS

Advantages and features of the disclosure, and implementation methods thereof, will be clarified through the following embodiments described with reference to the accompanying drawings. However, the disclosure may be embodied in different forms and should not be construed as limited to the embodiments set forth herein. Rather, these embodiments are provided so that the disclosure will be thorough and complete, and will fully convey the scope of the disclosure to those skilled in the art. Further, the disclosure is defined only by the categories of the claims.

The same reference numerals designate the same constituent elements. Thicknesses, ratios, and dimensions of constituent elements may be exaggeratedly expressed in the drawings, for effective description of the technical content. In addition, the dimensions and scales of constituent elements shown in the drawings are different from actual dimensions and scales, for convenience of description and, as such, the dimension scales of constituent elements are not limited to those shown in the drawings.

It will be understood that, when one constituent element (or an area, a layer, a portion, or the like) is referred to as being "disposed on", "connected to" or "coupled to" another constituent element, the one constituent element may be directly connected/coupled to the other constituent element, or a third constituent element may be disposed between the two constituent elements. The term "and/or" is used to include one or more combinations of associated configurations. It will be understood that, although the terms "first", "second", etc. may be used herein to describe various elements, these elements should not be limited by these terms. These terms are only used to distinguish one element from another. For example, a first element referred to in the following description may represent a second element, without departing from the scope of the disclosure. Similarly, the second element may represent the first element. Unless clearly used otherwise, singular expressions include a plural meaning.

Terms such as "below," "lower," "above," and "upper" are used to describe the relationships between the components shown in the drawings. These terms are relative concepts and are explained based on the orientations indicated in the drawings. For instance, unless "directly" or "immediately" is used, one or more other components may be disposed between two parts. Spatially relative terms such as "below", "beneath", "lower," "above," and "upper" may be employed to easily describe the correlation between one device or component and other devices or components, as represented in the drawings. These spatially relative terms should be understood as encompassing different orientations of the devices when used or during operation, in addition to the directions shown in the drawings. For example, if the device in one of the drawings is turned over, elements described as "below" or "beneath" other elements would then be oriented "above" the other elements. Therefore, the exemplary term "below" may encompass both downward and upward directions.

In this specification, it is to be understood that a term, such as "include" or "have", is intended to designate that a characteristic, a number, a step, an operation, an element, a part or a combination of them described in the specification is present, and does not preclude the presence or addition possibility of one or more other characteristics, numbers, steps, operations, elements, parts, or combinations thereof. Features of various embodiments of the present disclosure can be partially or overall coupled to or combined with each other, and can be variously inter-operated with each other and driven technically as those skilled in the art can sufficiently understand. The embodiments of the present disclosure can be carried out independently from each other, or can be carried out together in a co-dependent relationship.

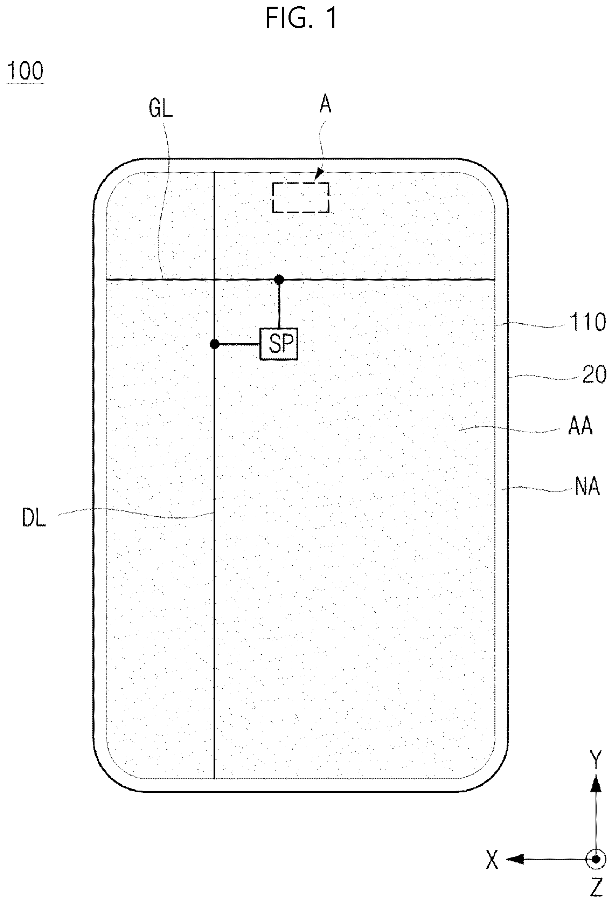

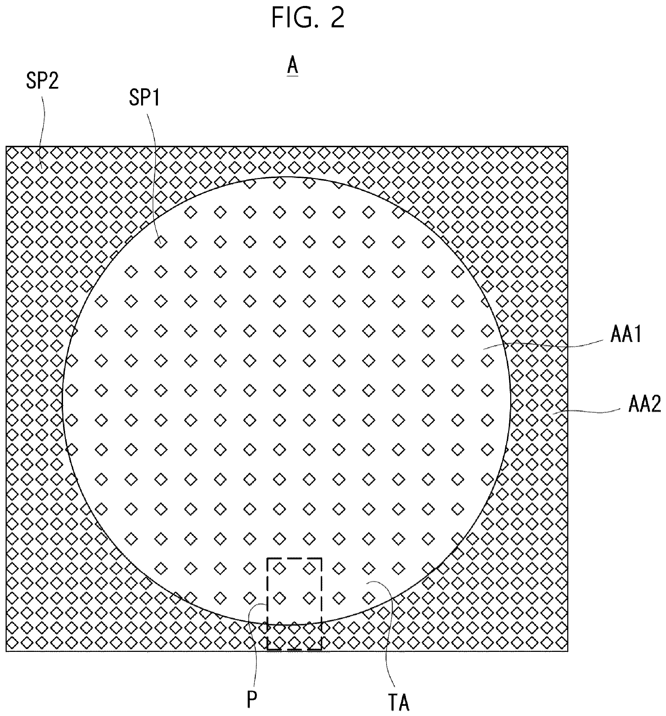

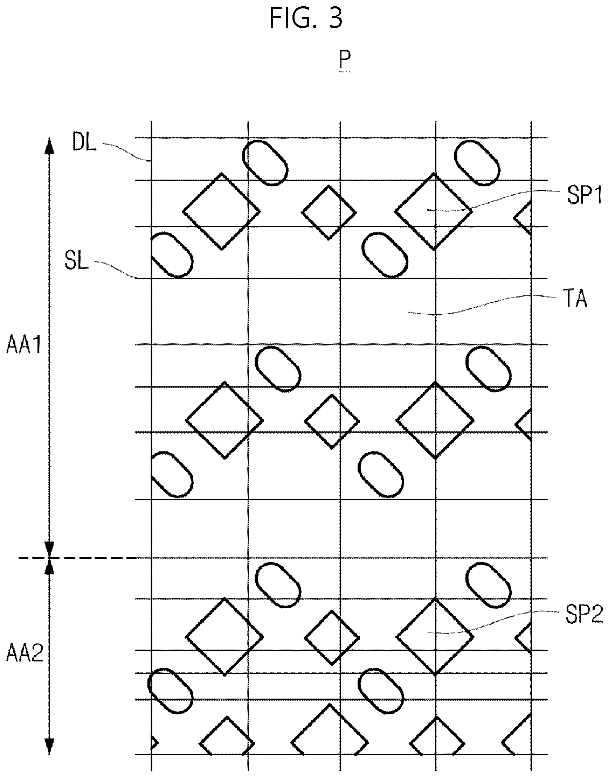

Hereinafter, a detailed description will be given of a display device according to embodiments of the present disclosure in conjunction with the attached drawings. In particular, FIG. 1 is a schematic plan view of a display device 100 , FIG. 2 is an enlarged plan view of a portion A of the display device 100 depicted in FIG. 1, and FIG. 3 is an enlarged plan view of a portion P of the display device 100 depicted in FIG. 2 according to an embodiment.

Referring to FIGS. 1 and 2, the display device 100 includes a display panel 110 including an active area AA and a non-active area NA, and a cover member 20 disposed on the display panel 110. The cover member 20 can be disposed on the display panel 110 to cover part of or an entire front surface of the display panel 110 and, as such, can protect the display panel 110 from external impact. The cover member 20 can also have, at an edge portion thereof, a curved portion or a curved surface portion configured to be bent in a backside direction (a -Z-axis direction) of the display device 100. By virtue of the curved portion or curved surface portion, the cover member 20 can be disposed to cover even a side surface area of the display panel 110 disposed at a back surface of the display panel 110. Accordingly, the cover member 20 can protect the display panel 110 from external impact at a side surface of the display panel 110 as well as at the front surface of the display panel 110.

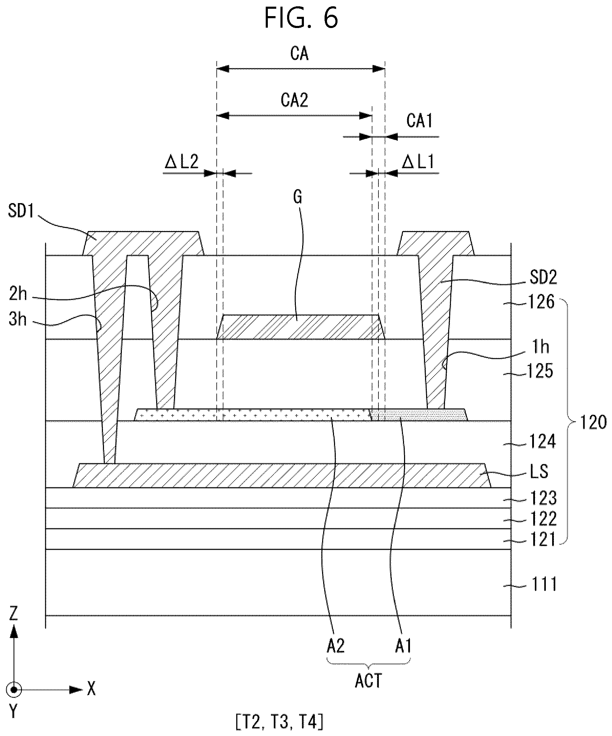

Further, the active area AA of the display device 100 displays an image is displayed, and an area of the display device 100 other than the active area AA can be referred to as the non-active area NA. The active area AA and the non-active area NA of the display device 100 can also be applied identically to the display panel 110. The display device 100 includes a substrate (see "111" in FIG. 6 and below) having both the active area AA and the non-active area NA. In the active area AA on the substrate 111, a plurality of data lines DL extending in a first direction and a plurality of gate lines GL extending in a second direction intersecting the first direction can be disposed. The active area AA can include an area where a camera or another type sensor can be disposed.

Further, areas defined by intersection of the data lines DL and the gate lines GL can constitute subpixels SP. Each of the subpixels SP can be defined as an area where a light-emitting part is disposed. However, a location of any subpixels SP is not limited to the area defined by intersection of each data line DL and each gate line GL. In addition, the subpixels SP can be implemented to emit light of the same color, for example, white (W), on a subpixel basis or can be implemented to emit light of different colors such as red (R), green (G), and blue (B) on a subpixel basis.

Referring to FIGS. 2 and 3, the active area AA can include a first area AA1 and a second area AA2, and the area division of the active area AA can be identically applied to the substrate (see "111" in FIG. 6 and below). The first area AA1 is the area where a camera or other sensor can be disposed, as described above. The second area AA2 refers to an area other than the first area AA1, where the camera or other sensor is not disposed. The first area AA1 includes a plurality of first subpixels SP1 and a transmissive part TA while the second area AA2 includes a plurality of second subpixels SP2 without inclusion of a transmissive part TA.

As is shown in FIG. 2, the transmissive part TA of the first area AA1 can be disposed adjacent to, and disposed among, the plurality of first subpixels SP1 to allow the camera or other sensor to receive or sense an image or external light from above the substrate 111. Since the first area AA1 includes the transmissive part TA, which can accommodate light sensing of the camera or other sensor, a density of the first subpixels SP1 in the first area AA1 is lower than the density of the second subpixels SP2 in the second area AA2. Accordingly, the number of the first subpixels SP1 disposed per unit area in the first area AA1 can be less than the number of the second subpixels SP2 disposed per unit area in the second area AA2. In addition, the first area AA1 can have a lower resolution than the second area AA2.

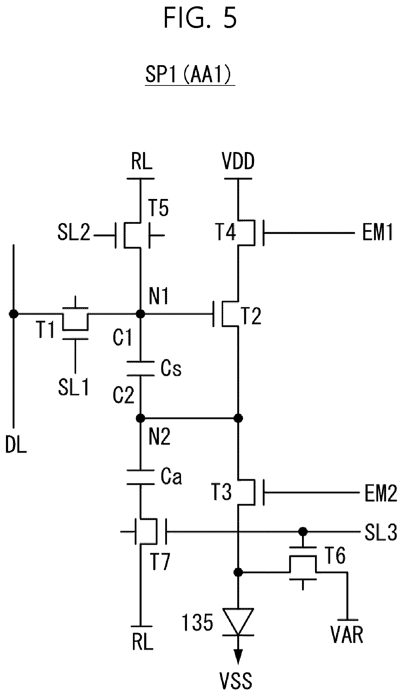

Adjacent ones of the first subpixels SP1 in the first area AA1 can include light-emitting elements (see "135" in FIG. 5) configured to emit light of different colors, respectively. Similarly, adjacent ones of the second subpixels SP2 in the second area AA2 can include light-emitting elements (see "135" in FIG. 5) configured to emit light of different colors, respectively. In the first area AA1 and the second area AA2, a plurality of data lines DL and a plurality of scan lines SL are disposed. In the first area AA1, however, the light-emitting elements (see "135" in FIG. 5) are disposed under the condition the transmissive part TA is disposed among the light-emitting elements differently from the second area AA2 while observing that the first subpixels SP1 in the first area AA1 and the second subpixels SP2 in the second area AA2 can include the same circuit configuration.

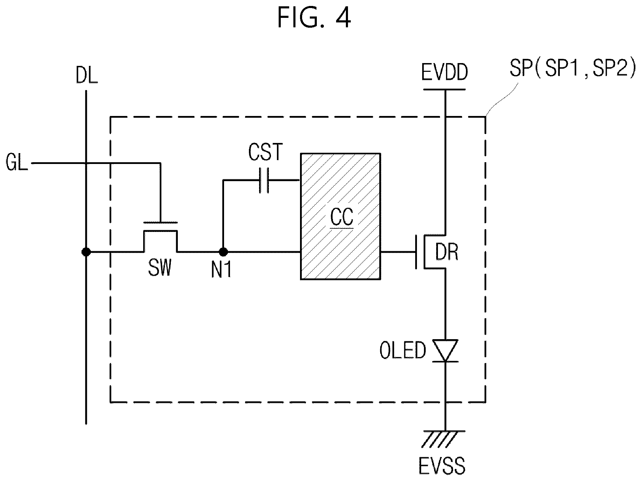

Turning to FIG. 4, an example circuit diagram for each first subpixel of the display device is shown. In particular, each first subpixel SP1 can include a switching transistor SW, a driving transistor DR, a capacitor Cst, a compensation circuit CC, and a light-emitting diode OLED.

The switching transistor SW is electrically connected to a data line DL and is also electrically connected to a first node N1. A gate electrode of the switching transistor SW is electrically connected to a gate line GL. The switching transistor SW transmits a data signal supplied through the data line DL to the first node N1 in response to a scan signal supplied through the gate line GL. The capacitor Cst is electrically connected to the first node N1 to charge a voltage applied to the first node N1.

As is shown in FIG. 4, the driving transistor DR is configured to receive a high-level drive voltage EVDD and is electrically connected to a first electrode (for example, an anode) of the light-emitting diode OLED. In operation, the driving transistor DR can control an amount of drive current flowing through the light-emitting diode OLED in response to a voltage applied to a gate electrode thereof. It is to be appreciated that semiconductor layers of the switching transistor SW and the driving transistor DR can include an oxide semiconductor material such as indium-gallium-zinc oxide (IGZO).

In addition, the light-emitting diode OLED or another light-emitting element, which will be described later, outputs light corresponding to the drive current and can output light corresponding to one of red, green, blue, and white. The light-emitting diode OLED can include a first electrode, an emission layer disposed on the first electrode, and a second electrode configured to supply a common voltage with the emission layer implemented to emit light of the same color, for example, white, on a pixel basis or can be implemented to emit light of different colors such as red, green, and blue on a subpixel (SP) basis.

In operation, the first electrode can function as an anode, whereas the second electrode can serve as a cathode. The light-emitting diode OLED can be a top emission type diode or a bottom emission type diode. Also, the light-emitting diode OLED is substantially identical to a light-emitting element (see "135" in FIG. 5) which will be described later.

Further, the compensation circuit CC can be provided within the first subpixel SP1 to compensate a threshold voltage, etc. of the driving transistor DR with the compensation circuit CC including or more transistors and/or one or more transistors and one or more capacitors configured in various ways in accordance with compensation methods applied thereto. In various examples, pixels including the compensation circuit CC can have various structures such as 3T1C, 4T2C, 5T2C, 6T1C, 6T2C, 7T1C, 7T2C, etc. For example, a plurality of transistors can be electrically connected between the driving transistor DR and the light-emitting diode OLED.

As stated above, the light-emitting diode OLED of FIG. 4 can be an organic light-emitting diode. However, other types of light-emitting elements, such an inorganic semiconductor-based LEDs, can be applied. Further, the various transistors, such as the switching transistor SW, the driving transistor DR, etc. can have a double-gate structure in which gate electrodes are disposed at upper and lower sides with reference to an active layer, respectively.

Also, FIG. 5 is a circuit diagram of a first subpixel SP1 of a display device according to another embodiment. Referring to FIG. 5, a first subpixel SP1 includes a first transistor T1, a second transistor T2, a third transistor T3, and a light-emitting element 135 electrically connected to the third transistor T3. The first subpixel SP1 further includes a first capacitor Cs electrically connected to the second transistor T2 and the third transistor T3. The first subpixel SP1 can further include fourth to seventh transistors T4, T5, T6, and T7, and a second capacitor Ca. Each of the first to seventh transistors T1, T2, T3, T4, T5, T6, and T7 can independently be a p-type transistor or an n-type transistor. Each of the first to seventh transistors T1, T2, T3, T4, T5, T6, and T7 is turned on when a high voltage is applied to a gate thereof.

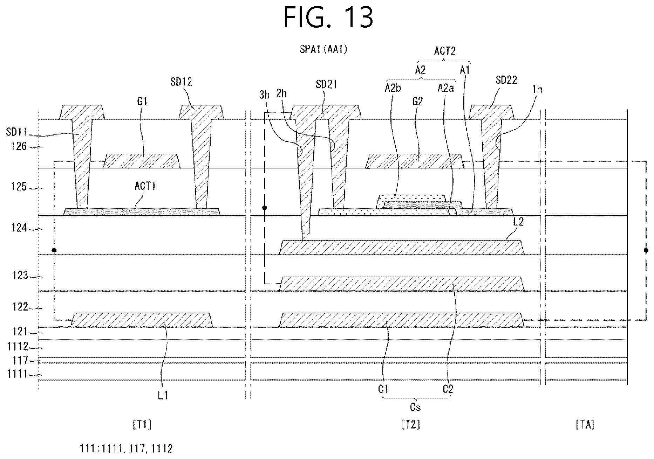

The first transistor T1 can be connected to a data line DL and, as such, can function as a switching transistor for supply of data. The gate of the first transistor T1 is connected to a first scan line SL1, and a first source-drain electrode of the first transistor T1 is connected to the data line DL. A second source-drain electrode of the first transistor T1 is connected to a first capacitor electrode (see "C1" in FIG. 13) of the first capacitor Cs and the gate of the second transistor T2 at a first node N1.

Also, the second transistor T2 is connected to the first transistor T1 and can function as a driving transistor. An upper gate of the second transistor T2 is connected to the second electrode of the first transistor T1 at the first node N1, and the second transistor T2 can be disposed between the third transistor T3 and the fourth transistor T4. Further, a first source-drain electrode of the second transistor T2 is connected to the fourth transistor T4 to which a high-level drive voltage EVDD is supplied, whereas a second source-drain electrode of the second transistor T2 is connected to a first source-drain electrode of the third transistor T3 at a second node N2. The second transistor T2 can further include a lower gate electrode. In operation, the second transistor T2 supplies drive current flowing between the third and fourth transistors T3 and T4 to a first electrode of the light-emitting element 135 through the second node N2, based on signals applied to first and second emission lines EM1 and EM2.

Further, the first source-drain electrode of the third transistor T3 is connected to the second source-drain electrode of the second transistor T2 at the second node N2, whereas a second source-drain electrode of the third transistor T3 can be connected to the first electrode of the light-emitting element 135. In operation, the third transistor T3 transmits, to the light-emitting element 135, a signal proportional to the high-level drive voltage EVDD or a signal proportional to an initialization voltage Vini in accordance with the signal supplied to the second emission line EM2.

As is further shown in FIG. 5, the gates of the fourth transistor T4 and the third transistor T3 are connected to the first and second emission lines EM1 and EM2, respectively. Accordingly, each of the fourth transistor T4 and the third transistor T3 can adjust supply of drive current to the light-emitting element 135. Moreover, a first source-drain electrode of the fourth transistor T4 is connected to a first power voltage line VDD to which the high-level drive voltage EVDD is supplied, whereas a second source-drain electrode of the fourth transistor T4 is connected to the first source-drain electrode of the second transistor T2. In operation, the fourth transistor T4 can supply, to the first source-drain electrode of the second transistor T2, a voltage proportional to the high-level drive voltage EVDD in accordance with the signal supplied by the first emission line EM1.

Also, the fifth transistor T5 is connected to a reference voltage line RL to supply a reference voltage to the first capacitor electrode C1 of the first capacitor Cs. The gate of the fifth transistor T5 is connected to a second scan line SL2, a first source-drain electrode of the fifth transistor T5 is connected to the reference voltage line RL, and a second source-drain electrode of the fifth transistor T5 is connected to the first capacitor electrode C1 of the first capacitor Cs and the gate of the second transistor T2 at the first node N1. In this situation, the first source-drain electrode of the fifth transistor T5 can also be electrically connected to the lower gate electrode of the second transistor T2.

In operation, when a gate signal is applied to the gate of the fifth transistor T5 via the second scan line SL2, the reference voltage is applied to the first node N1 through the fifth transistor T5 and is then supplied to the first capacitor electrode C1 of the first capacitor Cs. Further, the sixth transistor T6 transmits a reset voltage to the light-emitting element 135, and can function as an initialization transistor. The gate of the sixth transistor T6 is connected to a third scan line SL3, a first source-drain electrode of the sixth transistor T6 is connected to a reset line VAR to which a reset voltage is supplied, and a second source-drain electrode of the sixth transistor T6 is connected to the second source-drain electrode of the third transistor T3. Thus, when a signal from the third scan line SL3 is applied to the gate of the sixth transistor T6, the sixth transistor T6 transmits the reset voltage to the first electrode of the light-emitting element 135.

In addition, the second capacitor Ca, which is an auxiliary capacitor, is connected between the second node N2 and the reference voltage line RL, to which the reference voltage is applied. Accordingly, the second capacitor Ca can maintain the potential of the second node N2 at the reference voltage or above. Thus, when a signal is supplied to the gate of the seventh transistor T7 through the third scan line SL3, the seventh transistor T7 can transmit to one electrode of the second capacitor Ca a voltage proportional to the reference voltage transmitted to the reference voltage line RL.

As is stated above, the example light-emitting element 135 includes a first electrode, an emission layer, and a second electrode and can represent a color selected from, for example, white, red, green, and blue. The first electrode of the light-emitting element 135 is connected to the second source-drain electrode of the third transistor T3 to receive a voltage proportional to the high-level drive voltage EVDD through the first power voltage line VDD, and the second electrode of the light-emitting element 135 is connected to a second power voltage line VSS to receive a low-level drive voltage through the second power voltage line VSS.

Further, the first and third to seventh transistors T1, T3, T4, T5, T6, and T7 can be configured to have lower gate electrodes and to have threshold voltage adjustment configurations different from those of the second transistor T2 configured to supply the drive current. Further, the second transistor T2, the third transistor T3, and the fourth transistor T4 can have substantially the same structure. In the following description, structures of the second transistor T2, the third transistor T3, and the fourth transistor T4 will be described with reference to FIGs. 6 to 10.

Referring to FIG. 6, each of the second transistor T2, the third transistor T3, and the fourth transistor T4 can be formed on substrate 111 among a plurality of insulating layers 120. Each of the second transistor T2, the third transistor T3, and the fourth transistor T4 includes a gate electrode G, an active layer ACT overlapping with the gate electrode G to have a channel region CA and including an oxide semiconductor material, a first source-drain electrode SD1, and a second source-drain electrode SD2. The active layer ACT includes a first active layer A1 and a second active layer A2, and also includes a region where the second active layer A2 and the gate electrode G do not overlap each other. In the region where the second active layer A2 and the gate electrode G do not overlap each other, the first active layer A1 is connected to the second source-drain electrode SD2. In addition, the first active layer A1 and the second active layer A2 have different carrier mobilities, and in various examples the first active layer A1 can have a lower carrier mobility than the second active layer A2.

Also, the gate electrode G is disposed on a fifth insulating layer 125 to overlap with at least a portion of the active layer ACT under the condition the fifth insulating layer 125 is interposed between the gate electrode G and the active layer ACT. Also, the first source-drain electrode SD1 and the second source-drain electrode SD2 are disposed on a sixth insulating layer 126 in a state of being spaced apart from each other to be insulated from the gate electrode G under the condition the sixth insulating layer 126 is interposed between the gate electrode G and each of the first source-drain electrode SD1 and the second source-drain electrode SD2. Still further, the source or drain function of the first source-drain electrode SD1 and the second source-drain electrode SD2 can be defined depending on whether the corresponding transistor is a PMOS transistor or an NMOS transistor. When the first source-drain electrode SD1 serves as a source, the second source-drain electrode SD2 functions as a drain, whereas, when the first source-drain electrode SD1 functions as a drain, the second source-drain electrode SD2 serves as a source. In operation, each of the second transistor T2, the third transistor T3, and the fourth transistor T4 can be a unidirectional device in which current flows from the first source-drain electrode SD1 to the second source-drain electrode SD2.

As is also seen in FIG. 6, the second source-drain electrode SD2 can be connected to the first active layer A1 through first contact holes 1h of the fifth insulating layer 125 and the sixth insulating layer 126. Also, the first source-drain electrode SD1 can be connected to the second active layer A2 through second contact holes 2h of the fifth insulating layer 125 and the sixth insulating layer 126. Still further, the first source-drain electrode SD1 can be connected to a lower metal LS disposed beneath the active layer ACT through third contact holes 3h of a fourth insulating layer 124, the fifth insulating layer 125, and the sixth insulating layer 126. The fourth insulating layer 124 is interposed between the active layer ACT and the lower metal LS. However, in other embodiments, the lower metal LS can be electrically connected to the gate electrode G, to a ground, to a power line, e.g., VDD or VSS, or to another constant voltage source, such as a programmable voltage source allowing for a threshold voltage to be adjusted.

In various examples, the second transistor T2, third transistor T3, and fourth transistor T4 can have increased S-factor values as respective second source-drain electrodes SD2 thereof are electrically connected to the lower metal LS disposed beneath the active layer ACT in addition to an electrical connection thereof to the active layer ACT. The S-factor in the context of thin-film transistors (TFTs), also known as the "subthreshold swing" or "subthreshold slope factor" of a TFT, refers the change in gate voltage required to change the drain current of the TFT. The S-factor measures how effectively a TFT can switch from an off state to an on state, indicating the steepness of the transition in the subthreshold region of the TFT's current-voltage (I-V) characteristics. A lower S-factor indicates a sharper transition. Accordingly, when the second transistor T2 is applied to a driving transistor for control of drive current of the light-emitting element 135, and the third transistor T3 and the fourth transistor T4 are applied to light-emitting transistors controlled by emission lines, in accordance with the present discourse, there is an advantage in terms of gradation representation and, as such, the display device incorporating the second transistor T2, the third transistor T3, and the fourth transistor T4 can achieve sufficient gradation representation.

As is also shown in FIG. 6, the first active layer A1 and the second active layer A2 can be disposed in parallel on a stacked structure of first to fourth insulating layers 121, 122, 123, and 124. Both the first active layer A1 and the second active layer A2 are disposed on the insulating layer 124 and directly contact an upper surface of the insulating layer 124 in an area overlapping the gate electrode G. The first active layer A1 and the second active layer A2 can be disposed to have a single layer structure, and the first active layer A1 and the second active layer A2 can be disposed where the length of the second active layer A2 in a lateral direction is greater than the length of the first active layer A1 in the lateral direction. Also, the first active layer A1 can be made of an oxide semiconductor material with low carrier mobility characteristics, whereas the second active layer A2 can be made of an oxide semiconductor material with high carrier mobility characteristics.

The terms "low carrier mobility" (or "low-mobility") and "high carrier mobility" (or "high-mobility") as used in the present disclosure are relative concepts. Relatively smaller carrier mobility can be designated to a low carrier mobility, and relatively larger carrier mobility can be designated to a high carrier mobility, through comparison between carrier mobilities of the first active layer A1 and the second active layer A2. In other words, the first active layer A1 made of an oxide semiconductor material with low carrier mobility characteristics will have lower carrier mobility than the second active layer A2 made of an oxide semiconductor material with high carrier mobility characteristics.

The first active layer A1 can include at least one of an InGaZnO (IGZO)-based oxide semiconductor material (Ga concentration ≥ In concentration), a GaZnO (GZO)-based oxide semiconductor material, an InGaO (IGO)-based oxide semiconductor material, or a GaZnSnO (GZTO)-based oxide semiconductor material. For example, the first active layer A1 can have a carrier mobility in a range of about 5 to 12 cm²/V·s, without being limited thereto.

The second active layer A2 can include at least one of an InGaZnO (IGZO)-based oxide semiconductor material (In concentration > Ga concentration), an InZnO (IZO)-based oxide semiconductor material, an InGaZnSnO (IGZTO)-based oxide semiconductor material, an InSnZnO (ITZO)-based oxide semiconductor material, a FeInZnO (FIZO)-based oxide semiconductor material, a ZnO-based oxide semiconductor material, an SiInZnO (SIZO)-based oxide semiconductor material, or a Zn-oxynitride (ZnON)-based oxide semiconductor material. For example, the second active layer A2 can have a carrier mobility in a range of about 20 to 50 cm²/V·s, without being limited thereto.

The region of the active layer ACT overlapping with the gate electrode G can serve as the channel region CA. The region where the first active layer A1 constituting the active layer ACT overlaps with the gate electrode G can become a first channel region CA1, whereas the region where the second active layer A2 overlaps with the gate electrode G can become a second channel region CA2. The region of the active layer ACT not overlapping with the gate electrode G in a vertical direction can become a conductive region.

The active layer ACT includes a region where the second active layer A2 and the gate electrode G do not overlap each other. In the region where the second active layer A2 and the gate electrode G do not overlap each other, the first active layer A1 is connected to the second source-drain electrode SD2. The active layer ACT also includes a region where the first active layer A1 and the gate electrode G do not overlap each other. In the region where the first active layer A1 and the gate electrode G do not overlap each other, the second active layer A2 is connected to the first source-drain electrode SD1.

As is further shown in FIG. 6, the second active layer A2 is disposed to have a larger region overlapping with the gate electrode G than the first active layer A1. Accordingly, the length of the high-mobility second channel region CA2 can be greater than the length of the low-mobility first channel region CA1. In operation, when the first active layer A1 and the second active layer A2 are disposed in parallel on a co-plane, both the first channel region CA1 and the second channel region CA2 can function as a main channel region. The term "main channel region" means a region in the active layer where a relatively large number of carriers move. Further, current can flow from the first source-drain electrode SD1 to the second source-drain electrode SD2 after passing sequentially through the second channel region CA2 and the first channel region CA1. In this situation, since the length of the high-mobility second channel region CA2 is greater than the length of the low-mobility first channel region CA1, the high-mobility second channel region CA2 can occupy most of the main channel region. Also, in each of the second transistor T2, the third transistor T3, and the fourth transistor T4, most of the channel region CA of the active layer ACT constituting the main channel region is constituted by the second active layer A2 with a higher carrier mobility than the carrier mobility of the first active layer A1. Accordingly, high current can flow through the transistors and, as such, a display device with high luminance can be realized. Also, the first channel region CA1 of the first active layer A1 can include a first conductivity penetration length ΔL1, whereas the second channel region CA2 of the second active layer A2 can include a second conductivity penetration length ΔL2. The first conductivity penetration length ΔL1 and the second conductivity penetration length ΔL2 can correspond to portions of the first channel region CA1 and the second channel region CA2 treated to have conductivity, respectively.

Also, the portions of the first conductivity penetration length ΔL1 and the second conductivity penetration length ΔL2 can have a higher carrier concentration than the channel region CA. During a conductivization process (i.e., a process of making a material more conductive), the portions of the first conductivity penetration length ΔL1 and the second conductivity penetration length ΔL2, which are edges of the channel region CA, can have increased conductivity as compared to a center of the channel region CA. A length portion of the channel region CA excluding the portions of the first conductivity penetration length ΔL1 and the second conductivity penetration length ΔL2 can be defined as an effective channel region, and the length of the first channel region CA1 can be greater than the first conductivity penetration length ΔL1. Since the effective channel region of the first active layer A1 corresponds to a length portion of the first channel region CA1 excluding the portion of the first conductivity penetration length ΔL1, it can be possible to secure a low-mobility effective channel region for the first active layer A1 so long as the length of the first channel region CA1 is greater than at least the first conductivity penetration length ΔL1.

In addition, each of the second transistor T2, the third transistor T3, and the fourth transistor T4 has a respective first active layer A1 disposed so as to allow the first channel region CA1 to have a length greater than at least the first conductivity penetration length ΔL1 not overlapping with the second active layer A2. Thus, each of the second transistor T2, the third transistor T3, and the fourth transistor T4 can secure an effective channel region in the first channel region CA1 of the first active layer A1, which has a lower carrier mobility than the second active layer A2.

In each of the second transistor T2, the third transistor T3, and the fourth transistor T4 according to the present disclosure, the first active layer A1 connected to the second source-drain electrode SD2 can have a lower carrier mobility than the second active layer A2, and the second source-drain electrode SD2 can be connected to the first active layer A1, which has the first channel region CA1 with an effective channel region having a lower carrier concentration than the second channel region CA2. Accordingly, it can be possible to reduce defects in the channel region and a hot carrier stress phenomenon, i.e., electron trapping, caused by strong collisions of carriers, etc. in the vicinity of the second source-drain electrode SD2.

By configuring the first active layer A1, which is connected to the second source-drain electrode SD2, to have a lower carrier mobility than the second active layer A2, the carrier concentration in the first channel region CA1 can be reduced. Accordingly, even when current flows unidirectionally from the first source-drain electrode SD1 to the second source-drain electrode SD2, generation of hot carrier stress in the first active layer A1 in the vicinity of the first channel region CA1 can be reduced.

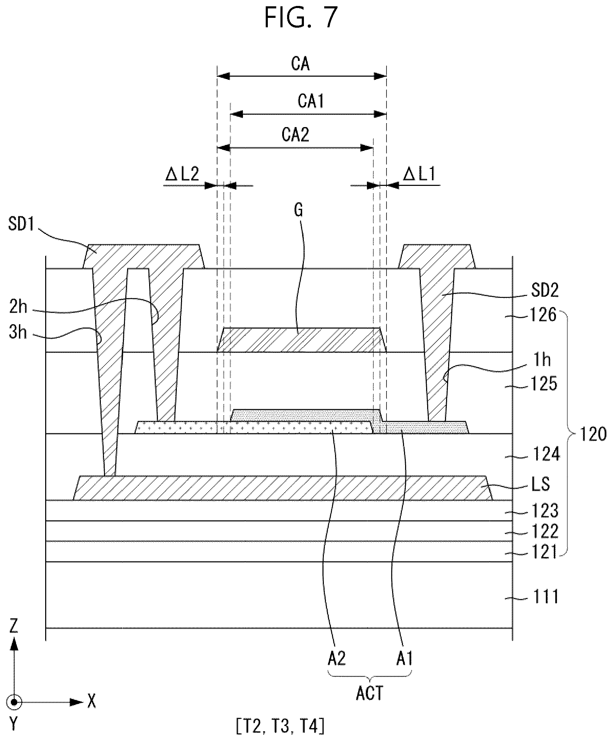

In the following description, transistors T2, T3, and T4 will be described with reference to FIGs. 7 to 10. However, in second to fifth embodiments described below, redundant details overlapping with the transistors according to the first embodiment described with reference to FIG. 6 can be omitted. Components having the same reference numerals as those described with reference to FIGs. 1 to 6 can be identically applied or implemented in other embodiments of the present disclosure, or can be applied or implemented in embodiments combined or integrated with other embodiments.

Referring to FIG. 7, an active layer ACT in each of the second transistor T2, the third transistor T3, and the fourth transistor T4 according to the second embodiment can be disposed to have a multilayer structure constituted by two layers. For example, a first active layer A1 can be disposed to extend in a direction toward a first source-drain electrode SD1 to allow the first active layer A1 to cover an upper surface of a second active layer A2. In a first layer, both the first active layer A1 and the second active layer A2 can be disposed, whereas, in a second layer, the first active layer A1 can be disposed to extend from the first layer to allow the first active layer A1 to cover a portion of the upper surface of the second active layer A2.

Also, the first active layer A1 and the second active layer A2 can have different carrier mobilities, e.g., the first active layer A1 can have a lower carrier mobility than the second active layer A2. Also, the first active layer A1 can be made of an oxide semiconductor material with low carrier mobility characteristics, whereas the second active layer A2 can be made of an oxide semiconductor material with high carrier mobility characteristics. Again, the terms "low carrier mobility" (or "low-mobility") and "high carrier mobility" (or "high-mobility") as used in the present disclosure are relative concepts. A relatively smaller carrier mobility can be designated to a low carrier mobility, and a relatively larger carrier mobility can be designated to a high carrier mobility, through comparison between mobilities of the first active layer A1 and the second active layer A2.

The first active layer A1 can include at least one of an InGaZnO (IGZO)-based oxide semiconductor material (Ga concentration ≥ In concentration), a GaZnO (GZO)-based oxide semiconductor material, an InGaO (IGO)-based oxide semiconductor material, or a GaZnSnO (GZTO)-based oxide semiconductor material. For example, the first active layer A1 can have a carrier mobility in a range of about 5 to 12 cm²/V·s, without being limited thereto. The second active layer A2 can include at least one of an InGaZnO (IGZO)-based oxide semiconductor material (In concentration > Ga concentration), an InZnO (IZO)-based oxide semiconductor material, an InGaZnSnO (IGZTO)-based oxide semiconductor material, an InSnZnO (ITZO)-based oxide semiconductor material, a FeInZnO (FIZO)-based oxide semiconductor material, a ZnO-based oxide semiconductor material, a SiInZnO (SIZO)-based oxide semiconductor material, or a Zn-oxynitride (ZnON)-based oxide semiconductor material. For example, the second active layer A2 can have a carrier mobility in a range of about 20 to 50 cm²/V·s, without being limited thereto.

The region of the active layer ACT overlapping with a gate electrode G can serve as a channel region CA. In detail, the region where the first active layer A1 of the active layer ACT overlaps with the gate electrode G is defined as a first channel region CA1, whereas the region where the second active layer A2 overlaps with the gate electrode G can be defined as a second channel region CA2. That is, in the embodiment shown in FIG. 7, the active layer ACT comprises a structure with the first active layer A1 and the second active layer A2 stacked at a central portion of the channel region CA. Also, most of the channel region CA of the active layer ACT constituting a main channel region is constituted by the second active layer A2 with a higher carrier mobility than the carrier mobility of the first active layer A1. Accordingly, high current can flow through the transistors and, as such, a display device with high luminance can be realized.

Each of the second transistor T2, the third transistor T3, and the fourth transistor T4 has the first active layer A1 disposed to allow the first channel region CA1 to have a length greater than at least a first conductivity penetration length ΔL1 does not overlap with the second active layer A2. Thus, each of the second transistor T2, the third transistor T3, and the fourth transistor T4 can secure an effective channel region in the first channel region CA1 of the first active layer A1, which has a lower carrier mobility than the second active layer A2.

As the first active layer A1 is disposed closer to the gate electrode G than the second active layer A2, the second active layer A2 can be configured to have a higher carrier mobility than the carrier mobility of the first active layer A1 by about 10 cm²/V·s or above in order to form the main channel region in the second channel region CA2. Consequently, a flow of main current can proceed to a second source-drain electrode SD2 after passing through the second channel region CA2 and the first channel region CA1 disposed in the first layer.

In a region where the first and second active layers A1 and A2 overlap each other, the first channel region CA1 on the upper surface of the second active layer A2 can function as a protective capping layer configured to protect the second channel region CA2 and can also serve to block any damage to the second channel region CA2 during processing. In the second transistor T2, the third transistor T3, and the fourth transistor T4 according to the second embodiment, it can be possible to increase the intensity of current flowing through the transistors by configuring the second active layer A2 to have relatively high carrier mobility. Also, in the second transistor T2, the third transistor T3, and the fourth transistor T4, it can be possible to reduce the carrier concentration of the first channel region CA1 by configuring the first active layer A1 connected to the second source-drain electrode SD2 to allow the first active layer A1 to have a lower carrier mobility than the second active layer A2. Accordingly, even when current flows unidirectionally from the first source-drain electrode SD1 to the second source-drain electrode SD2, generation of hot carrier stress in the first active layer A1 in the vicinity of the first channel region CA1 can be reduced. Moreover, in the second transistor T2, the third transistor T3, and the fourth transistor T4 according to the second embodiment, damage to the second channel region CA2, which forms the main channel region, can be prevented by the first active layer A1. Accordingly, reliability of the devices can be enhanced.

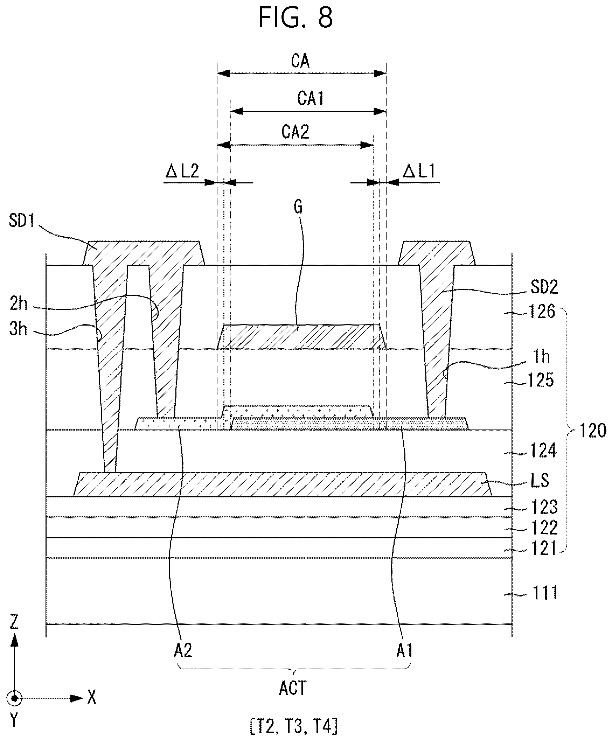

Referring to FIG. 8, an active layer ACT in each of the second transistor T2, the third transistor T3, and the fourth transistor T4 according to the third embodiment can be disposed to have a multilayer structure constituted by two layers. A second active layer A2 can be disposed to extend in a direction toward a second source-drain electrode SD2 to allow the second active layer A2 to cover an upper surface of a first active layer A1. In a first layer, both the second active layer A2 and the first active layer A1 can be disposed, whereas, in a second layer, the second active layer A2 can be disposed to extend from the first layer to allow the second active layer A2 to cover a portion of the upper surface of the first active layer A1.

Also, the first active layer A1 and the second active layer A2 have different mobilities, i.e., the first active layer A1 can have a lower carrier mobility than the second active layer A2. The first active layer A1 can also be made of an oxide semiconductor material with low carrier mobility characteristics, whereas the second active layer A2 can be made of an oxide semiconductor material with high carrier mobility characteristics. Again, the terms "low carrier mobility" (or "low-mobility") and "high carrier mobility" (or "high-mobility") as used in the present disclosure are relative concepts. A relatively smaller carrier mobility can be designated to a low carrier mobility, and a relatively larger carrier mobility can be designated to a high carrier mobility, through comparison between carrier mobilities of the first active layer A1 and the second active layer A2.

The first active layer A1 can include at least one of an InGaZnO (IGZO)-based oxide semiconductor material (Ga concentration ≥ In concentration), a GaZnO (GZO)-based oxide semiconductor material, an InGaO (IGO)-based oxide semiconductor material, or a GaZnSnO (GZTO)-based oxide semiconductor material. For example, the first active layer A1 can have a carrier mobility in a range of about 5 to 12 cm²/V·s, without being limited thereto. The second active layer A2 can include at least one of an InGaZnO (IGZO)-based oxide semiconductor material (In concentration > Ga concentration), an InZnO (IZO)-based oxide semiconductor material, an InGaZnSnO (IGZTO)-based oxide semiconductor material, an InSnZnO (ITZO)-based oxide semiconductor material, a FeInZnO (FIZO)-based oxide semiconductor material, a ZnO-based oxide semiconductor material, a SiInZnO (SIZO)-based oxide semiconductor material, or a Zn-oxynitride (ZnON)-based oxide semiconductor material. For example, the second active layer A2 can have a carrier mobility in a range of about 20 to 50 cm²/V·s, without being limited thereto.

The region of the active layer ACT overlapping with a gate electrode G can serve as a channel region CA. The region where the first active layer A1 constituting the active layer ACT overlaps with the gate electrode G can become a first channel region CA1, whereas the region where the second active layer A2 overlaps with the gate electrode G can become a second channel region CA2. Most of the channel region CA of the active layer ACT constituting a main channel region is constituted by the second active layer A2 with a higher carrier mobility than the carrier mobility of the first active layer A1. Accordingly, high current can flow through the transistors and, as such, a display device with high luminance can be realized.

Each of the second transistor T2, the third transistor T3, and the fourth transistor T4 has the first active layer A1 disposed to allow the first channel region CA1 to have a length greater than at least a first conductivity penetration length ΔL1 does not overlap with the second active layer A2. Thus, each of the second transistor T2, the third transistor T3, and the fourth transistor T4 can secure an effective channel region in the first channel region CA1 of the first active layer A1, which has a lower carrier mobility than the second active layer A2. Further, the length of the first channel region CA1 of the first active layer A1 can be greater than the length of the second channel region CA2 of the second active layer A2 disposed in the first layer. As the second channel region CA2 of the second active layer A2 is disposed to extend in the direction toward the second source-drain electrode SD2, the length of the second channel region CA2 of the second active layer A2 can be increased.

However, the second active layer A2, which is disposed on the upper surface of the first active layer A1, is disposed so as not to cover a predetermined portion of the first channel region CA1 of the first active layer A1. Thus, the second active layer A2 is disposed to allow at least a portion thereof to not overlap with the gate electrode G in a region where the first active layer A1 overlaps with the gate electrode G in order to enable the predetermined portion of the first channel region CA1 of the first active layer A1 to secure an effective channel region. For example, an end of the second active layer A2 disposed in the second layer is disposed to extend as far as possible without penetrating a region corresponding to a first conductivity penetration length ΔL1. As the second active layer A2 is disposed closer to the gate electrode G than the first active layer A1, the second channel region CA2 of the second active layer A2 on the upper surface of the first active layer A1 can serve as the main channel region.

Further, the flow direction of current can proceed from the first source-drain electrode SD1 toward the second source-drain electrode SD2 through the second channel region CA2 in the first layer, the second channel region CA2 in the second layer, and the first channel region CA1 in the first layer in this order. In a region where the first channel region CA1 and the second channel region CA2 overlap each other, a flow of main current is generated in the second channel region CA2 having a relatively high carrier mobility. At an edge of the second channel region CA2, current can flow from the high-mobility second channel region CA2 in the second layer to the low-mobility first channel region CA1.

Further, in the second transistor T2, the third transistor T3, and the fourth transistor T4 according to the third embodiment, it can be possible to reduce the carrier concentration of the first channel region CA1 by configuring the first active layer A1 connected to the second source-drain electrode SD2 to allow the first active layer A1 to have a lower carrier mobility than the second active layer A2 and securing the effective channel region of the first channel region CA1 of the first active layer A1. Also, in the second transistor T2, the third transistor T3, and the fourth transistor T4 according to the third embodiment, accordingly, even when current flows unidirectionally from the first source-drain electrode SD1 to the second source-drain electrode SD2, generation of hot carrier stress in the first active layer A1 in the vicinity of the first channel region CA1 can be reduced.

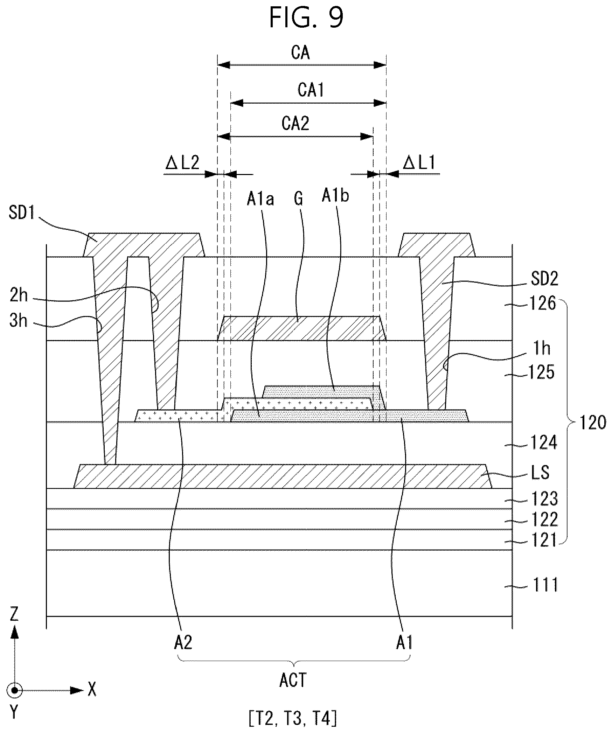

Referring to FIG. 9, each of the second transistor T2, the third transistor T3, and the fourth transistor T4 according to the fourth embodiment of the present disclosure can include an active layer ACT stacked to have a multilayer structure. As is shown in FIG. 9, the active layer ACT includes a first active layer A1 and a second active layer A2. As with previous examples, the first active layer A1 and the second active layer A2 have different mobilities, e.g., the first active layer A1 can have a lower carrier mobility than the second active layer A2. The first active layer A1 can also be made of an oxide semiconductor material with low carrier mobility characteristics, whereas the second active layer A2 can be made of an oxide semiconductor material with high carrier mobility characteristics. Once more, the terms "low carrier mobility" (or "low-mobility") and "high carrier mobility" (or "high-mobility") as used in the present disclosure are relative concepts. A relatively smaller carrier mobility can be designated to a low carrier mobility, and a relatively larger carrier mobility can be designated to a high carrier mobility, through comparison between carrier mobilities of the first active layer A1 and the second active layer A2.

The first active layer A1 can include at least one of an InGaZnO (IGZO)-based oxide semiconductor material (Ga concentration ≥ In concentration), a GaZnO (GZO)-based oxide semiconductor material, an InGaO (IGO)-based oxide semiconductor material, or a GaZnSnO (GZTO)-based oxide semiconductor material. For example, the first active layer A1 can have a carrier mobility in a range of about 5 to 12 cm²/V·s, without being limited thereto. The second active layer A2 can include at least one of an InGaZnO (IGZO)-based oxide semiconductor material (In concentration > Ga concentration), an InZnO (IZO)-based oxide semiconductor material, an InGaZnSnO (IGZTO)-based oxide semiconductor material, an InSnZnO (ITZO)-based oxide semiconductor material, a FeInZnO (FIZO)-based oxide semiconductor material, a ZnO-based oxide semiconductor material, a SiInZnO (SIZO)-based oxide semiconductor material, or a Zn-oxynitride (ZnON)-based oxide semiconductor material. For example, the second active layer A2 can have a carrier mobility in a range of about 20 to 50 cm²/V·s, without being limited thereto.

In addition, the region of the active layer ACT overlapping with a gate electrode G can serve as a channel region CA with the region where the first active layer A1 overlaps the gate electrode G defined as a first channel region CA1, and the region where the second active layer A2 overlaps the gate electrode G defined as a second channel region CA2. Most of the channel region CA of the active layer ACT constituting a main channel region is constituted by the second active layer A2 with a higher carrier mobility than the carrier mobility of the first active layer A1. Accordingly, high current can flow through the transistors and, as such, a display device with high luminance can be realized.

Also, each of the second transistor T2, the third transistor T3, and the fourth transistor T4 has the first active layer A1 disposed to allow the first channel region CA1 to have a length greater than at least a first conductivity penetration length ΔL1 not overlapping with the second active layer A2. Thus, each of the second transistor T2, the third transistor T3, and the fourth transistor T4 can secure an effective channel region in the first channel region CA1 of the first active layer A1, which has a lower carrier mobility than the second active layer A2.

In addition, the first active layer A1 can include a first lower active layer A1a disposed to allow a portion thereof to be covered by the second active layer A2, and a first upper active layer A1b extending from the first lower active layer A1a to cover at least a portion of the second active layer A2 covering the portion of the first lower active layer A1a. Also, the first lower active layer A1a extends to be disposed beneath the second active layer A2, whereas the first upper active layer A1b extends to be disposed on an upper surface of the second active layer A2, and the length of the first upper active layer A1b of the first active layer A1 is less than the length of the first lower active layer A1a of the first active layer A1. That is, in the embodiment shown in FIG. 9, the active layer ACT comprises a structure with the first active layer A1 and the second active layer A2 alternately stacked at a central portion of the channel region CA, with the second active layer A2 interposed between the first lower active layer A1a and the first upper active layer A1b of the first active layer A1.

Further, carrier mobilities of the first upper active layer A1b and the first lower active layer A1a can be substantially equal. However, in other embodiments, carrier mobility of the first upper active layer A1b can be greater than carrier mobility of the first lower active layer A1a. Similarly, in still other embodiments, carrier mobility of the first upper active layer A1b can be less than carrier mobility of the first lower active layer A1a.

Again referring to FIG. 9, as the first upper active layer A1b is disposed to cover at least a portion of the upper surface of the second active layer A2, an uppermost surface of the first upper active layer A1b can be disposed closer to the gate electrode G than an uppermost surface of the second active layer A2. As the first upper active layer A1b is disposed closer to the gate electrode G than the second active layer A2, the carrier mobility difference between the second active layer A2 and the first active layer A1 can be set to be great in order to enable formation of a main channel region in the second active layer A2 beneath the first upper active layer A1b. In this situation, the carrier mobility of the second active layer A2 can be set to be higher than the carrier mobility of the first active layer A1 by 10 cm²/V·s or above. Accordingly, this embodiment can enable the second channel region CA2 of the second active layer A2, which is relatively farther from the gate electrode G, to serve as the main channel region, instead of the first channel region CA1 of the first upper active layer A1b, which is closer to the gate electrode G.

In operation, the flow direction of current can proceed from the first source-drain electrode SD1 toward the second source-drain electrode SD2 through the second channel region CA2 in the first layer, the second channel region CA2 of the second active layer A2 on the upper surface of the first active layer A1, and the first channel region CA1 in the first layer, in this order. Also, the first upper active layer A1b, which covers the upper surface of the channel region CA2 of the second active layer A2, and the first lower active layer A1a, which is disposed in the first layer to cover a lower surface of the channel region CA2 of the second active layer A2, can function as a protective capping layer configured to protect the second channel region CA2 of the second active layer A2 disposed between the first upper active layer A1b and the first lower active layer A1a. In addition, the first upper active layer A1b and the first lower active layer A1a can block any damage to the second channel region CA2 of the second active layer A2 during processing.

In the second transistor T2, the third transistor T3, and the fourth transistor T4 according to the fourth embodiment, it can be possible to prevent damage to the second channel region CA2, which forms the main channel region, by configuring the active layer ACT to have a multilayer structure and covering at least a portion of the upper surface of the second active layer A2 and the lower surface of the second active layer A2 by the first active layer A1, which has a lower carrier concentration than a carrier concentration of the second active layer A2. Accordingly, reliability of the devices can be enhanced. In the second transistor T2, the third transistor T3, and the fourth transistor T4 according to the fourth embodiment, it can be possible to secure the first channel region CA1 of the first active layer A1 by configuring the first active layer A1, which is connected to the second source-drain electrode SD2, to have a lower carrier mobility than the second active layer A2, and disposing the second active layer A2 to have a portion not overlapping with the gate electrode G. Accordingly, the carrier concentration of the first channel region CA1 can be reduced. In the second transistor T2, the third transistor T3, and the fourth transistor T4 according to the fourth embodiment of the present disclosure, accordingly, even when current flows unidirectionally from the first source-drain electrode SD1 to the second source-drain electrode SD2, the second source-drain electrode SD2 can reduce generation of hot carrier stress in the first active layer A1 in the vicinity of the first channel region CA1.

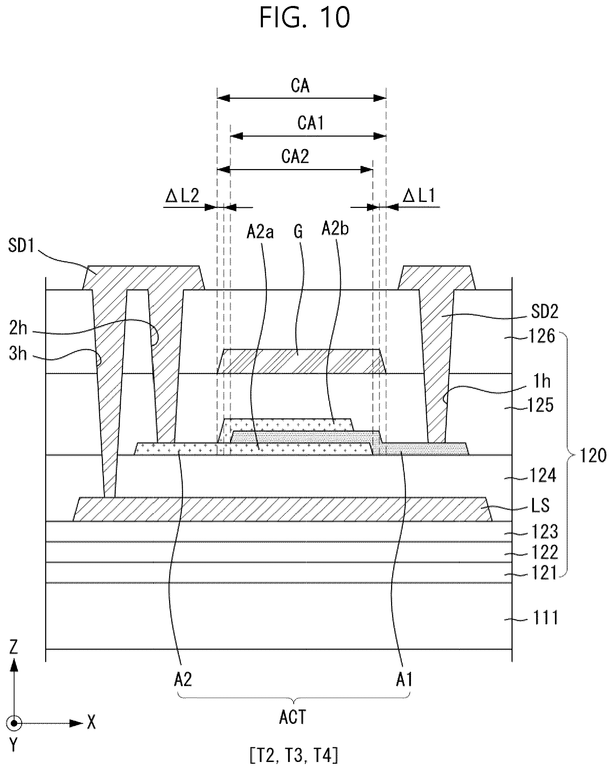

Referring to FIG. 10, each of the second transistor T2, the third transistor T3, and the fourth transistor T4 according to the fifth embodiment of the present disclosure can include an active layer ACT stacked to have a multilayer structure. As is shown in FIG. 10, the active layer ACT includes a first active layer A1 and a second active layer A2.

As with previous examples, the first active layer A1 and the second active layer A2 have different mobilities, e.g., the first active layer A1 can have a lower carrier mobility than the second active layer A2. The first active layer A1 can also be made of an oxide semiconductor material with low carrier mobility characteristics, whereas the second active layer A2 can be made of an oxide semiconductor material with high carrier mobility characteristics. Once more, the terms "low carrier mobility" (or "low-mobility") and "high carrier mobility" (or "high-mobility") as used in the present disclosure are relative concepts. A relatively smaller carrier mobility can be designated to a low carrier mobility, and a relatively larger carrier mobility can be designated to a high carrier mobility, through comparison between carrier mobilities of the first active layer A1 and the second active layer A2.

The first active layer A1 can include at least one of an InGaZnO (IGZO)-based oxide semiconductor material (Ga concentration ≥ In concentration), a GaZnO (GZO)-based oxide semiconductor material, an InGaO (IGO)-based oxide semiconductor material, or a GaZnSnO (GZTO)-based oxide semiconductor material. For example, the first active layer A1 can have a carrier mobility in a range of about 5 to 12 cm²/V·s, without being limited thereto. The second active layer A2 can include at least one of an InGaZnO (IGZO)-based oxide semiconductor material (In concentration > Ga concentration), an InZnO (IZO)-based oxide semiconductor material, an InGaZnSnO (IGZTO)-based oxide semiconductor material, an InSnZnO (ITZO)-based oxide semiconductor material, a FeInZnO (FIZO)-based oxide semiconductor material, a ZnO-based oxide semiconductor material, a SiInZnO (SIZO)-based oxide semiconductor material, or a Zn-oxynitride (ZnON)-based oxide semiconductor material. For example, the second active layer A2 can have a carrier mobility in a range of about 20 to 50 cm²/V·s, without being limited thereto.

Also as with previous examples, the region of the active layer ACT overlapping with a gate electrode G can serve as a channel region CA with the region where the first active layer A1 overlaps the gate electrode G defined as a first channel region CA1, and the region where the second active layer A2 overlaps the gate electrode G defined as a second channel region CA2.. Also, most of the channel region CA of the active layer ACT constituting a main channel region is constituted by the second active layer A2 with a higher carrier mobility than the carrier mobility of the first active layer A1. Accordingly, high current can flow through the transistors and, as such, a display device with high luminance can be realized.

As is shown in FIG. 10, the second active layer A2 can include a second lower active layer A2a disposed to be covered by the first active layer A1 at a portion thereof, and a second upper active layer A2b extending from the second lower active layer A2a to cover at least a part of the portion of the first active layer A1 covering the second lower active layer A2a. Also, the second lower active layer A2a extends to be disposed beneath the first active layer A1, and the second upper active layer A2b extends to be disposed on an upper surface of the first active layer A1. Still further, the length of the second upper active layer A2b of the second active layer A2 is less than the length of the second lower active layer A2a of the second active layer A2. That is, in the embodiment shown in FIG. 10, the active layer ACT comprises a structure with the first active layer A1 and the second active layer A2 alternately stacked at a central portion of the channel region CA, with the first active layer A1 interposed between the second lower active layer A2a and the second upper active layer A2b of the second active layer A2.

In addition, the second upper active layer A2b and the second lower active layer A2a can be disposed to have substantially the same carrier mobility. However, in other embodiments, carrier mobility of the second upper active layer A2b can be greater than carrier mobility of the second lower active layer A2a. Similarly, in still other embodiments, carrier mobility of the second upper active layer A2b can be less than carrier mobility of the second lower active layer A2a.

In the present example, in a first layer, the second active layer A2 and the first active layer A1 can be disposed. In a second layer, the first active layer A1 can be disposed. In a third layer, the second active layer A2 can be disposed. The first active layer A1 of the first layer and the first active layer A1 of the second layer can be connected to each other along a side surface of the second active layer A2 of the first layer, and the second active layer A2 of the first layer and the second active layer A2 of the third layer can be connected to each other along a side surface of the first active layer A1 of the second layer.

In addition, as the second upper active layer A2b is disposed to cover at least a portion of the upper surface of the first active layer A1, an uppermost surface of the second upper active layer A2b can be disposed closer to the gate electrode G than an uppermost surface of the first active layer A1. Also, as the second upper active layer A2b is disposed so as not to cover a portion of the first channel region CA1 of the first active layer A1, at least a portion of the first channel region CA1 of the first active layer A1 is ensured to secure an effective channel region. To achieve this, the second active layer A2 is disposed to allow at least a portion of the second active layer A2 to not overlap with the gate electrode G in a region where the first active layer A1 overlaps with the gate electrode G. For example, an end of the second upper active layer A2b can extend as far as possible without penetrating a region corresponding to a first conductivity penetration length ΔL1.

Further, the active layer ACT can be configured to have a structure in which the first active layer A1 having a lower carrier mobility than the second active layer A2 is surrounded by the second active layer A2 in the form of a sandwich structure. Accordingly, the low-mobility first active layer A1 having a lower carrier mobility than the second active layer A2 can have a structure separating the high-mobility second active layers A2 from each other. Since the second active layer A2 is disposed closer to the gate electrode G than the first active layer A1 and has a higher carrier mobility than the first active layer A1, the second upper active layer A2b can serve as the main channel region.

In operation, the flow direction of main current can proceed from the first source-drain electrode SD1 toward the second source-drain electrode SD2 through the second channel region CA2 and the first channel region CA1 of the first active layer A1 in this order. The main current flowing from the first source-drain electrode SD1 can also flow to the second source-drain electrode SD2 after sequentially passing through a portion of the second channel region CA2 of the second lower active layer A2a in the first layer, the second channel region CA2 of the second upper active layer A2b in the third layer, the first channel region CA1 of the first active layer A1 in the second layer, and the first channel region CA1 of the first active layer A1 in the first layer.

In operation, the second lower active layer A2a disposed in the first layer can function as a carrier supporter layer configured to replenish carriers to the second upper active layer A2b. For example, when a voltage is applied to the gate electrode G, the second lower active layer A2a positioned at a bottom can also be affected by a gate field. As a result, carriers in the second lower active layer A2a can move to the second upper active layer A2b. Accordingly, the second upper active layer A2b can be replenished with carriers.

In the second transistor T2, the third transistor T3, and the fourth transistor T4 according to the present disclosure, it can be possible to easily achieve interface control between the second upper active layer A2b having the main channel region and the fifth insulating layer 125 and to maintain stability of threshold voltages of the transistors, using a method of indirectly increasing the carrier mobility of the second upper active layer A2b, for example, a method of transferring carriers of the second lower active layer A2a to the second upper active layer A2b, in place of a method of directly increasing the carrier mobility of the second upper active layer A2b. Additionally, as carriers are replenished in the second upper active layer A2b by the second lower active layer A2a, the carrier mobility of A2b is indirectly increased. Accordingly, it can be possible to increase intensity of current passing through the channel region CA while maintaining stability of the threshold voltage of each transistor.

In operation, the first active layer A1 disposed between the second upper active layer A2b and the second lower active layer A2a can function as a separation layer configured to structurally separate the second upper active layer A2b and the second lower active layer A2a from each other. Accordingly, in each transistor according to this embodiment, as the first active layer A1 structurally separates the second upper active layer A2b and the second lower active layer A2a from each other, it can be possible to not only prevent a significant direct increase in the thickness of the second upper active layer A2b for an increase in current intensity, but also to reduce a hot carrier stress phenomenon in the active layer ACT adjacent to the second source-drain electrode SD2 through the first active layer A1.

As described above, each of the second transistor T2, the third transistor T3, and the fourth transistor T4 includes active layers ACT with different carrier mobilities to allow the active layer having a lower carrier mobility to be disposed at a downstream end in a current flow direction to secure an effective channel region. Accordingly, it can be possible to not only prevent deterioration of device reliability caused by a hot carrier stress phenomenon, but also to enhance luminance through an increase in current intensity.

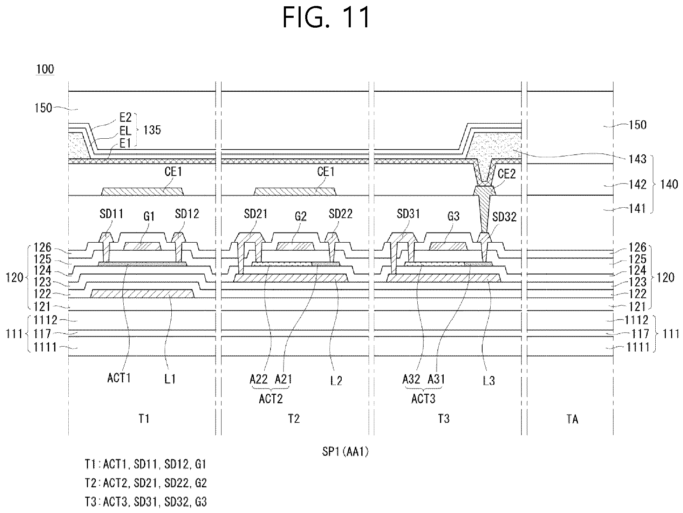

Hereinafter, the display device 100, to which the above-described transistors are applied, will be described with reference to FIG. 11. As is shown in FIG. 11, the display device 100 includes a first transistor T1, a second transistor T2, a third transistor T3, and a light-emitting element 135 electrically connected to the third transistor T3, all disposed on a substrate 111 in a first area AA1 having a transmissive part TA. The display device 100 can further include a plurality of insulating layers 120 and a plurality of planarization layers 140 disposed between electrodes constituting the first to third transistors T1, T2, and T3 or between the first to third transistors T1, T2, and T3 and the light-emitting element 135, and an encapsulation layer 150 disposed on the light-emitting element 135.

The substrate 111 serves to support and protect components of the display device 100 disposed over the substrate 111. The substrate 111 can include a plastic material with flexibility and, as such, can have flexible characteristics. In an active area AA, the substrate 111 can be formed to have a multilayer structure including a first flexible substrate 1111 and a second flexible substrate 1112 under a condition where an interlayer 117 is interposed between the first flexible substrate 1111 and the second flexible substrate 1112. The first flexible substrate 1111 can form an upper surface of the substrate 111, and the second flexible substrate 1112 can form a lower surface of the substrate 111. For example, the first flexible substrate 1111 and the second flexible substrate 1112 can include polyimide.

The first flexible substrate 1111 and the second flexible substrate 1112 are coupled to each other via an interlayer 117 with the interlayer 117 including, for example, an inorganic insulating material, such as silicon nitride (SiNₓ) or silicon oxide (SiOₓ). The interlayer 117 can be disposed in the entirety of the active area AA between the first flexible substrate 1111 and the second flexible substrate 1112.

In addition, the plurality of insulating layers 120 can be stacked and disposed in the active area AA of the substrate 111. The insulating layers 120 can include a first insulating layer 121, a second insulating layer 122, a third insulating layer 123, a fourth insulating layer 124, a fifth insulating layer 125, and a sixth insulating layer 126. The first to sixth insulating layers 121 to 126 are illustrated to explain insulating relationships, etc., among the transistors T1 to T7 and the electrodes constituting the transistors T1 to T7. Accordingly, the number of the insulating layers 120 on the substrate 111 is not limited to the above-illustrated conditions.

Further, the first insulating layer 121 can be referred to as a buffer layer and can perform the same function as a known buffer layer in the technical field. The first insulating layer 121 is disposed on the substrate 111 and can serve to protect structures on the substrate 111, which are vulnerable to moisture permeation, from moisture penetration through the substrate 111, as well as to planarize the surface of the substrate 111. The first insulating layer 121 can be formed as a single inorganic layer or as a stacked structure of multiple inorganic layers. For example, the first insulating layer 121 can include one or more inorganic layers selected from a silicon oxide (SiOₓ) layer, a silicon nitride (SiNₓ) layer, and a silicon oxynitride (SiOₓN_{y}) layer, or can include a multilayer structure in which the inorganic layers described above as examples are stacked.

As is further seen in FIG. 11, the second to fourth insulating layers 122 to 124 are disposed on the first insulating layer 121, and each of the second to fourth insulating layers 122 to 124 can include an inorganic layer, for example, a silicon oxide (SiOₓ) layer, a silicon nitride (SiNₓ) layer, or a multilayer structure in which the inorganic layers described are stacked. The second insulating layer 122 can also serve as an interlayer insulating layer to insulate transistors (not shown) constituting a gate driving circuit (not shown) disposed in a non-active area NA.

An active layer ACT1 of the first transistor T1, an active layer ACT2 of the second transistor T2, and an active layer ACT3 of the third transistor T3 are disposed on the fourth insulating layer 124 with the active layer ACT1 of the first transistor T1, the active layer ACT2 of the second transistor T2, and the active layer ACT3 of the third transistor T3 spaced apart from one another. The active layer ACT1 of the first transistor T1, the active layer ACT2 of the second transistor T2, and the active layer ACT3 of the third transistor T3 can also all be disposed on the same layer. The active layer ACT1 of the first transistor T1, the active layer ACT2 of the second transistor T2, and the active layer ACT3 of the third transistor T3 can all include the same material.

As with previous examples of active layers, each of the active layer ACT1 of the first transistor T1, the active layer ACT2 of the second transistor T2, and the active layer ACT3 of the third transistor T3 can include an oxide semiconductor material. The oxide semiconductor material included in each of the active layer ACT1 of the first transistor T1, the active layer ACT2 of the second transistor T2, and the active layer ACT3 of the third transistor T3 can include, for example, at least one of an InZnO (IZO)-based oxide semiconductor material, an InGaO (IGO)-based oxide semiconductor material, an InSnO (ITO)-based oxide semiconductor material, an InGaZnO (IGZO)-based oxide semiconductor material, an InGaZnSnO (IGZTO)-based oxide semiconductor material, a GaZnSnO (GZTO)-based oxide semiconductor material, a GaZnO (GZO)-based oxide semiconductor material, an InSnZnO (ITZO)-based oxide semiconductor material, or an FeInZnO (FIZO)-based oxide semiconductor material. The active layer ACT2 of the second transistor T2 and the active layer ACT3 of the third transistor T3 can include respective first active layers A11 and A21 and respective second active layers A12 and A22.

In addition, the fifth insulating layer 125 is disposed on the active layers ACT1, ACT2, and ACT3. The fifth insulating layer 125 is also disposed between gate electrodes G1, G2, and G3 and the active layers ACT1, ACT2, and ACT3, to insulate the gate electrodes G1, G2, and G3 and the active layers ACT1, ACT2, and ACT3 from each other. The fifth insulating layer (125) can include at least one of silicon oxide (SiOₓ), silicon nitride (SiNₓ), or silicon oxynitride (SiOₓN_{y}). For example, silicon oxide (SiOₓ) can include silicon dioxide (SiO₂).

On the fifth insulating layer 125, the gate electrode G1 of the first transistor T1, the gate electrode G2 of the second transistor T2, and the gate electrode G3 of the third transistor T3 are disposed. The gate electrode G1 of the first transistor T1, the gate electrode G2 of the second transistor T2, and the gate electrode G3 of the third transistor T3 are disposed to be spaced apart from one another. Also, the gate electrode G1 of the first transistor T1 is disposed to overlap with the active layer ACT1 of the first transistor T1 at least a portion thereof, the gate electrode G2 of the second transistor T2 is disposed to overlap with the active layer ACT2 of the second transistor T2 at least a portion thereof, and the gate electrode G3 of the third transistor T3 is disposed to overlap with the active layer ACT3 of the third transistor T3 at least a portion thereof. Each of the gate electrodes G1, G2, to G3 can include a conductive material. For example, each of the gate electrodes G1, G2, to G3 can include metals such as aluminum (Al), chromium (Cr), copper (Cu), titanium (Ti), molybdenum (Mo), and tungsten (W).

The sixth insulating layer 126 is disposed on the gate electrodes G1, G2, and G3. The sixth insulating layer 126 is disposed to cover the fifth insulating layer 125 and the gate electrodes G1, G2, and G3. The sixth insulating layer 126 can be referred to as an interlayer insulating layer and can perform the function of a known interlayer insulating layer in the related technical field. The sixth insulating layer 126 can include an inorganic material. The inorganic material can include one or more inorganic layers selected from a silicon oxide (SiOₓ) layer, a silicon nitride (SiNₓ) layer, and a silicon oxynitride (SiOₓN_{y}) layer, or can include a multilayer structure in which the inorganic layers described above as examples are stacked.

Also, a plurality of first source-drain electrodes SD11, SD21, and SD31 and a plurality of second source-drain electrodes SD12, SD22, and SD32 are disposed on the sixth insulating layer 126. The plurality of first source-drain electrodes SD11, SD21, and SD31 and the plurality of second source-drain electrodes SD12, SD22, and SD32 are also disposed to be spaced apart from one another, and each of the first source-drain electrodes SD11, SD21, and SD31 and the second source-drain electrodes SD12, SD22, and SD32 can include a conductive metal, such as aluminum (Al), titanium (Ti), copper (Cu), chromium (Cr), molybdenum (Mo), and tungsten (W).

Still further, an organic layer 140 is disposed on the first source-drain electrodes SD11, SD21, and SD31 and the second source-drain electrodes SD12, SD22, and SD32. The organic layer 140 can be disposed over the first to seventh transistors T1, T2, T3, T4, T5, T6, and T7 (see FIG. 5) disposed on the substrate 111 or can be disposed on the insulating layer 120 in order to protect the first to seventh transistors T1, T2, T3, T4, T5, T6, and T7 (see FIG. 5) and to alleviate steps formed by the first to seventh transistors T1, T2, T3, T4, T5, T6, and T7 (see FIG. 5). The organic layer 140 can also be disposed between the first to seventh transistors T1, T2, T3, T4, T5, T6 and T7 (see FIG. 5) and the light-emitting elements 135 to reduce the parasitic capacitance generated between these structures or devices, and can cover the first to seventh transistors T1, T2, T3, T4, T5, T6 and T7 (see FIG. 5) or can be disposed on the insulating layers 120 to provide a flat surface. The organic layer 140 can be a layer having a single-layer or multilayer structure of an organic material. For example, the organic layer 140 can include a first organic layer 141 and a second organic layer 142 on the first organic layer 141. Additionally, the organic layer 140 can further include a third organic layer 143 disposed on the second organic layer 142 to define an emission region of the light-emitting element 135. The first to third organic layers 141, 142, and 143 can include the same material. The first to third organic layers 141, 142, and 143 can include different materials, respectively. As is shown in FIG. 11, the first organic layer 141 covers one electrode of each transistor in the active area AA, for upper surface planarization, and can include at least one material of acrylic resin, phenolic resin, polyimide-based resin, unsaturated polyester resin, polyamide-based resin, benzocyclobutene, polyphenylene resin, or polyphenylene sulfide-based resin.

In addition, the second organic layer 142 covers each transistor and the first organic layer 141 in the active area AA, for upper surface planarization, and can include at least one material of acrylic resin, phenolic resin, polyimide-based resin, unsaturated polyester resin, polyamide-based resin, benzocyclobutene, polyphenylene resin, or polyphenylene sulfide-based resin. In addition to the above-described insulating layers 120, various other organic or inorganic layers with various functions can also be disposed between the substrate 111 and the organic layer 140.

As is also shown in FIG. 11, an upper metal CE1 and a connection electrode CE2 are disposed between the organic layers 140 with the upper metal CE1 and the connection electrode CE2 disposed to be spaced apart from each other between the first organic layer 141 and the second organic layer 142. Also, the upper metal CE1 can be disposed in plural, and each of the plural upper metals CE1 can be disposed to overlap with the active layer ACT1 of the first transistor T1 and the active layer ACT2 of the second transistor T2. As the plural upper metals CE1 is disposed to overlap with the active layer ACT1 of the first transistor T1 and the active layer ACT2 of the second transistor T2, respectively, it can be possible to decrease the influence of light on the active layers ACT1 and ACT2 of the first and second transistors T1 and T2. Still further, the connection electrode CE2 is disposed to overlap with the active layer ACT3 of the third transistor T3 and is electrically connected to a second source-drain electrode SD32 of the third transistor T3 with one end of the connection electrode CE2 electrically connected to the second source-drain electrode SD32 of the third transistor T3, and the other end of the connection electrode CE2 electrically connected to a first electrode E1 of the light-emitting element 135. Accordingly, as the second source-drain electrode SD32 of the third transistor T3 is electrically connected to the first electrode E1 of the light-emitting element 135 through the connection electrode CE2, current can be supplied to the light-emitting element 135. Additionally, as the connection electrode CE2 is disposed to overlap with the active layer ACT3 of the third transistor T3, it can be possible to reduce influence of light possibly applied to the active layer ACT3 of the third transistor T3. Each of the upper metal CE1 and the connection electrode CE2 can include a conductive material, such as aluminum (Al), chromium (Cr), copper (Cu), titanium (Ti), molybdenum (Mo), and tungsten (W).

The light-emitting element 135 is disposed on the organic layer 140 in the active area AA. Specifically, the light-emitting element 135 is disposed on the second organic layer 142 to be electrically connected to the third transistor T3. Also, the light-emitting element 135 includes an emission layer EL and a second electrode E2 in addition to the first electrode E1. Further, the first electrode E1 can function as an anode and can extend through the organic layer 140 to be electrically connected to each transistor. The first electrode E1 can also include a metal material having high reflectivity and can be referred to as a reflective electrode. For example, the first electrode E1 can be formed to have a multilayer structure such as a stacked structure Ti/Al/Ti of aluminum (Al) and titanium (Ti), a stacked structure ITO/Al/ITO of aluminum (Al) and ITO, an Ag/Pd/Cu (APC) alloy, a stacked structure ITO/APC/ITO of an APC alloy and ITO, and a stacked structure Ag/Mo/Ti of silver (Ag) and a molybdenum/titanium alloy, or can be formed to have a monolayer structure constituted by a material selected from silver (Ag), aluminum (Al), molybdenum (Mo), gold (Au), magnesium (Mg), calcium (Ca), or barium (Ba), or from two or more alloy materials.

Further, the emission layer EL is provided on the first electrode E1. The emission layer EL can include a hole injection layer, a hole transport layer, an organic emission layer, an electron transport layer, and an electron injection layer. Although the emission layer EL is shown in the drawing as being disposed in an opening area, the hole injection layer, the hole transport layer, the electron transport layer, and the electron injection layer constituting the emission layer EL can be disposed on the entire surface of the active area AA in common, and can include at least one of a red emission layer configured to emit red light, a green emission layer configured to emit green light, a blue emission layer configured to emit blue light, or a stacked structure of these layers. The emission layer EL can also be disposed on the first electrode E1 on a subpixel (SP) basis. The emission layer EL can still further be a white emission layer configured to emit white light. In this situation, the organic emission layer of the emission layer EL can be a common layer commonly disposed at subpixels SP without being disposed in the form of patterns. Also as described above, the emission layer EL can be disposed to have a tandem structure including two or more stacks. In this situation, each light-emitting element 135 can include a charge generation layer disposed between the stacks. The charge generation layer can be a common layer disposed on the entire surface of the active area AA.

Next, the second electrode E2 is provided on the emission layer EL, and can function as a cathode. Furthermore, the second electrode E2 can be disposed not only in an emission region of the subpixel SP, but also in the entirety of the active area AA. Still further, when the active area AA is functionally divided, the second electrode E2 can be disposed in the form of patterns. The second electrode E2 can be a common layer disposed at the subpixels SP in common to apply the same voltage to the subpixels SP. To achieve this, the second electrode E2 can extend from the active area AA up to a portion of the non-active area NA. In contrast to the first electrode E1, the second electrode E2 can be a transmissive electrode, and can include a transparent conductive material (TCO), such as ITO or IZO, or a semi-transmissive conductive material, such as magnesium (Mg), silver (Ag), or an alloy of magnesium (Mg) and silver (Ag). When the second electrode E2 includes a semi-transmissive conductive material, an enhancement in light emission efficiency can be achieved by virtue of micro-cavities.

Although a top emission type light-emitting element has been described as an example of the light-emitting element 135, the light-emitting element 135 is not limited thereto. The light-emitting element 135 can be of a bottom emission type in which light generated from the emission layer EL is emitted toward the substrate 111. In this situation, the first electrode E1 can be made of a transparent or semi-transparent electrode material, whereas the second electrode E2 can be made of a reflective electrode material. As materials suitable for transparent, semi-transparent, and reflective electrodes, the above-described materials can be employed.

In addition, the third organic layer 143 can be disposed on the second organic layer 142 to cover an end of the first electrode E1 of the light-emitting element 135. The third organic layer 143 can be referred to as a bank configured to define the emission region. The third organic layer 143 is disposed to open the first electrode E1 in the emission region on a subpixel (SP) basis where first electrodes E1 of adjacent ones of the subpixels SP are electrically insulated from each other. Using a halftone mask, the third organic layer 143 can be disposed to have a structure including not only banks, but also spacers disposed on the banks among the banks. The spacers function to support a deposition mask during deposition of the emission layer EL in order to prevent the deposition mask from contacting the banks and the structures under the banks. The third organic layer 143 can extend from the active area AA up to a portion of the non-active area NA, and can be disposed to have a patterned structure in the non-active area NA in accordance with a functional role thereof. Also, the third organic layer 143 can include a material different from a material of the first organic layer 141 or the second organic layer 142, and can include an organic material selected from polyimide resin, acryl resin, epoxy resin, phenolic resin, and polyamide resin.

Next, an encapsulation layer 150 is disposed on the light-emitting element 135, and can extend from the active area AA into and over the non-active area NA. In operation, the encapsulation layer 150 covers the active area AA and the non-active area NA to prevent oxygen or moisture from penetrating into the structures on the substrate 111, such as the light-emitting element 135 and the transistors. In addition, other layers such as a capping layer, etc. can be interposed between the encapsulation layer 150 and the second electrode E2. The encapsulation layer 150 can include a plurality of layers, and can have a structure in which inorganic and organic layers are alternately stacked. The encapsulation layer 150 can also be disposed on the entire upper surfaces of the transistors T1, T2, and T3 and the light-emitting element 135 in the active area AA, can completely cover the light-emitting element 135 to seal the light-emitting element 135, and can be disposed to extend from the active area AA up to a portion of the non-active area NA. In various embodiments, the inorganic layers constituting the encapsulation layer 150 can include silicon oxide, silicon nitride, and/or silicon oxynitride while the organic layers constituting the encapsulation layer 150 can include one or more organic materials selected from the group consisting of polyethylene terephthalate, polyethylene naphthalate, polycarbonate, polyimide, polyethylene sulfonate, polyoxymethylene, polyarylate, and hexamethyldisiloxane.

Also, because the first area AA1 has the transmissive part TA, the first area AA1 can be configured so the magnitude of an electric field affecting the active layer ACT varies in accordance with the functions of the transistors disposed in the first subpixel SP1. In an embodiment, the first transistor T1 disposed in the first area AA1 including the plurality of first subpixels SP1 and the transmissive part TA on the substrate 111 includes the gate electrode G1, the active layer ACT1 overlapping with the gate electrode G1 to have the channel region CA and including an oxide semiconductor material, the first source-drain electrode SD11, and the second source-drain electrode SD12. The active layer ACT1 of the first transistor T1 can include an oxide semiconductor material, for example, at least one of an InZnO (IZO)-based oxide semiconductor material, an InGaO (IGO)-based oxide semiconductor material, an InSnO (ITO)-based oxide semiconductor material, an InGaZnO (IGZO)-based oxide semiconductor material, an InGaZnSnO (IGZTO)-based oxide semiconductor material, a GaZnSnO (GZTO)-based oxide semiconductor material, a GaZnO (GZO)-based oxide semiconductor material, an InSnZnO (ITZO)-based oxide semiconductor material, or an FeInZnO (FIZO)-based oxide semiconductor material.

Next, the gate electrode G1 of the first transistor T1 is disposed to allow at least a portion thereof to overlap with the active layer ACT1. The gate electrode G1 and the active layer ACT1 of the first transistor T1 can be insulated from each other by the fifth insulating layer 125. In operation, the gate electrode G1 of the first transistor T1 can control formation of a channel in the channel region of the active layer ACT1 through a voltage applied thereto.

Further, the first source-drain electrode SD11 and the second source-drain electrode SD12 of the first transistor T1 are disposed on the sixth insulating layer 126 in a state of being insulated from the gate electrode G1 under the condition where the sixth insulating layer 126 is interposed between the gate electrode G1 and each of the first source-drain electrode SD11 and the second source-drain electrode SD12. The first source-drain electrode SD11 of the first transistor T1 contacts one side of the active layer ACT1, whereas the second source-drain electrode SD12 of the first transistor T1 contacts the other side of the active layer ACT1. The first transistor T1 can function as a switching transistor.

The carrier mobility of the active layer ACT1 of the first transistor T1 can be equal to or lower than the carrier mobility of the first active layer A21 of the active layer ACT2 of the second transistor T2, and can also be lower than the carrier mobility of the second active layer A22 of the active layer ACT2 of the seco0nd transistor T2. The carrier mobility of the active layer ACT1 of the first transistor T1 can be equal to or lower than the carrier mobility of a first active layer A31 of the active layer ACT3 of the third transistor T3, and can also be lower than the carrier mobility of a second active layer A32 of the active layer ACT3 of the third transistor T3. The first transistor T1 can further include a first lower metal L1 beneath the active layer ACT1.

The first lower metal L1 can be disposed between the first insulating layer 121 and the second insulating layer 122. Additionally, the second insulating layer 122, the third insulating layer 123, and the fourth insulating layer 124 can be disposed between the first lower metal L1 and the active layer ACT1 of the first transistor T1. The first lower metal L1 can be electrically connected to the gate electrode G1 of the first transistor T1. As the first lower metal L1 is electrically connected to the gate electrode G1 of the first transistor T1, it can be possible to enhance an electric field applied to the active layer ACT1 of the first transistor T1 when a turn-on voltage is applied to the gate electrode G1 of the first transistor T1. Accordingly, turn-on characteristics of the first transistor T1 can be enhanced. As compared to a structure in which no gate electrode is connected, accordingly, the first transistor T1 can generate relatively-higher drive current and, as such, control for the channel region of the active layer ACT1 can be performed more rapidly.

Further, the first lower metal L1 can include a conductive material, such as aluminum (Al), titanium (Ti), copper (Cu), chromium (Cr), molybdenum (Mo), and tungsten (W). The first lower metal L1 can also include a metal material different from a metal material of the gate electrode G1 of the first transistor TR1, can be disposed on a different layer from a second lower metal L2 or a third lower metal L3, and can include a same material or a different material from the second lower metal L2 or the third lower metal L3. Also, the second insulating layer 122 and the third insulating layer 123 can be disposed between the first lower metal L1 and the second lower metal L2 or between the first lower metal L1 and the third lower metal L3.

In operation, the second transistor T2 can function as a driving transistor, and can be disposed in the first area AA1 including the plurality of first subpixels SP1 and the transmissive part TA on the substrate 111. As is shown in FIG. 11, the second transistor T2 includes the gate electrode G2, the active layer ACT2, which overlaps the gate electrode G2 to form a channel region, the first source-drain electrode SD21, and the second source-drain electrode SD22.

The active layer ACT2 of the second transistor T2 can include an oxide semiconductor material, for example, at least one of an InZnO (IZO)-based oxide semiconductor material, an InGaO (IGO)-based oxide semiconductor material, an InSnO (ITO)-based oxide semiconductor material, an InGaZnO (IGZO)-based oxide semiconductor material, an InGaZnSnO (IGZTO)-based oxide semiconductor material, a GaZnSnO (GZTO)-based oxide semiconductor material, a GaZnO (GZO)-based oxide semiconductor material, an InSnZnO (ITZO)-based oxide semiconductor material, or an FeInZnO (FIZO)-based oxide semiconductor material.

The gate electrode G2 of the second transistor T2 is disposed to allow at least a portion thereof to overlap with the active layer ACT2. The gate electrode G2 and the active layer ACT2 of the second transistor T2 can be insulated from each other by the fifth insulating layer 125. The gate electrode G2 of the second transistor T2 can control formation of a channel in the channel region of the active layer ACT2 through a voltage applied thereto.

The first source-drain electrode SD21 and the second source-drain electrode SD22 of the second transistor T2 are disposed on the sixth insulating layer 126 in a state of being insulated from the gate electrode G2 under the condition where the sixth insulating layer 126 is interposed between the gate electrode G2 and each of the first source-drain electrode SD21 and the second source-drain electrode SD22. The first source-drain electrode SD21 of the second transistor T2 contacts one side of the active layer ACT2 of the second transistor T2, and the second source-drain electrode SD22 of the second transistor T2 contacts the other side of the active layer ACT2 of the second transistor T2. Specifically, the first source-drain electrode SD21 of the second transistor T2 contacts the second active layer A22 of the second transistor T2, and the second source-drain electrode SD22 of the second transistor T2 contacts the first active layer A21 of the second transistor T2.

The carrier mobility of the first active layer A21 contacting the second source-drain electrode SD22 of the second transistor T2 is lower than the carrier mobility of the second active layer A22 contacting the first source-drain electrode SD21 of the second transistor T2. The carrier mobility of the first active layer A21 of the second transistor T2 can be equal to the carrier mobility of the active layer ACT1 of the first transistor T1, whereas the carrier mobility of the second active layer A22 of the second transistor T2 can be higher than the carrier mobility of the active layer ACT1 of the first transistor T1.

The carrier mobility of the first active layer A21 of the second transistor T2 can be equal to the carrier mobility of the first active layer A31 of the active layer ACT3 of the third transistor T3, and can be lower than the carrier mobility of the second active layer A32 of the active layer ACT3 of the third transistor T3. The carrier mobility of the second active layer A22 of the second transistor T2 can be higher than the carrier mobility of the first active layer A31 of the active layer ACT3 of the third transistor T3, and can be equal to the carrier mobility of the second active layer A32 of the active layer ACT3 of the third transistor T3.

The second transistor T2 can further include the second lower metal L2 beneath the active layer ACT2. The second lower metal L2 can be disposed between the third insulating layer 123 and the fourth insulating layer 124. The fourth insulating layer 124 can be disposed between the second lower metal L2 and the active layer ACT2 of the second transistor T2. The second lower metal L2 can be electrically connected to the first source-drain electrode SD21 of the second transistor T2. In this situation, the second transistor T2 can block light by virtue of the second lower metal L2, thereby minimizing the influence of light on the active layer ACT2 of the second transistor T2. Additionally, when the second lower metal L2 is electrically connected to the first source-drain electrode SD21 of the second transistor T2, the sub-threshold swing (S-factor) or the on-current value of the second transistor T2 can be enhanced.

The second transistor T2 can be electrically connected to the light-emitting element 135 via the third transistor T3. In the display device 100 according to the present disclosure, an enhancement in S-factor can be achieved through electrical connection between the second lower metal L2 of the second transistor T2 and the first source-drain electrode SD21 of the second transistor T2. Due to the enhanced S-factor, the rate of variation of drain-source current Ids with respect to a gate voltage is small, resulting in a gradual variation in the drain-source current Ids according to gate voltage variation. Accordingly, it can be possible to stably control gradation representation.

Additionally, in the display device 100, an enhancement in on-current value can be achieved through electrical connection between the second lower metal L2 of the second transistor T2 and the first source-drain electrode SD21 of the second transistor T2. Accordingly, when the second transistor T2 is turned on, the concentration of carriers moving through the second transistor T2 can further increase, resulting in a further increase in current. Consequently, the luminance of the light-emitting element 135 connected via the third transistor T3 can be further increased.

In addition, the second lower metal L2 can include a conductive material, and can include, for example, metals such as aluminum (Al), titanium (Ti), copper (Cu), chromium (Cr), molybdenum (Mo), and tungsten (W). The second lower metal L2 can also include a metal material different from the metal material of the gate electrode G2 of the second transistor T2. Also, the second lower metal L2 can be disposed on a different layer from the first lower metal L1 or can include a different material from the first lower metal L1, or can be disposed on the same layer as the third lower metal L3 and can include the same material as the third lower metal L3.

The thickness of the insulating layer between the active layer ACT1 and the first lower metal L1 of the first transistor T1 can be greater than the thickness of the insulating layer between the active layer ACT2 and the second lower metal L2 of the second transistor T2. The second transistor T2, which has a relatively small insulating layer thickness between the active layer ACT2 and the second lower metal L2 thereof, can achieve stable gradation representation control because the variation in drain-source current Ids according to gate voltage variation can proceed gradually. Additionally, on-current values of the first and second transistors T1 and T2 can be controlled to be different from each other. The on-current of the first transistor T1 can be controlled to have a relatively increased value.

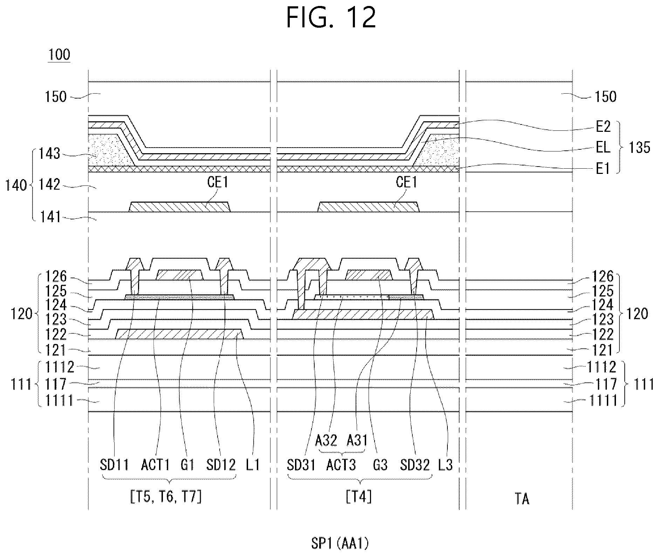

In operation, the third transistor T3 can function as a light-emitting transistor. Similarly, the fourth transistor T4 (see FIG. 12) can also function as a light-emitting transistor and can have the same structure as the third transistor T3. Accordingly, the following description will be given in detail in conjunction with the third transistor T3. The third transistor T3 is disposed in the first area AA1 including the first subpixels SP1 and the transmission part TA on the substrate 111. The third transistor T3 includes the gate electrode G3, the active layer ACT3 overlapping with the gate electrode G3 to have a channel region and including an oxide semiconductor material, the first source-drain electrode SD31, and the second source-drain electrode SD32. The active layer ACT3 of the third transistor T3 includes the first active layer A31 and the second active layer A32, and can include an oxide semiconductor material such as , for example, at least one of an InZnO (IZO)-based oxide semiconductor material, an InGaO (IGO)-based oxide semiconductor material, an InSnO (ITO)-based oxide semiconductor material, an InGaZnO (IGZO)-based oxide semiconductor material, an InGaZnSnO (IGZTO)-based oxide semiconductor material, a GaZnSnO (GZTO)-based oxide semiconductor material, a GaZnO (GZO)-based oxide semiconductor material, an InSnZnO (ITZO)-based oxide semiconductor material, or an FeInZnO (FIZO)-based oxide semiconductor material.

In addition, the gate electrode G3 of the third transistor T3 can be disposed to allow at least a portion thereof to overlap with the active layer ACT3 with the gate electrode G3 and the active layer ACT3 of the third transistor T3insulated from each other by the fifth insulating layer 125. In operation, the gate electrode G3 of the third transistor T3 can control formation of a channel in the channel region of the active layer ACT3 through a voltage applied thereto.

Next, the first source-drain electrode SD31 and the second source-drain electrode SD32 of the third transistor T3 are disposed on the sixth insulating layer 126 in a state of being insulated from the gate electrode G3 under the condition where the sixth insulating layer 126 is interposed between the gate electrode G3 and each of the first source-drain electrode SD31 and the second source-drain electrode SD32. The first source-drain electrode SD31 of the third transistor T3 contacts one side of the active layer ACT3 of the third transistor T3, and the second source-drain electrode SD32 of the third transistor T3 contacts the other side of the active layer ACT3 of the third transistor T3. Specifically, the first source-drain electrode SD31 of the third transistor T3 contacts the second active layer A32 of the third transistor T3, and the second source-drain electrode SD32 of the third transistor T3 contacts the first active layer A31 of the third transistor T3.

The first active layer A31 and the second active layer A32 of the third transistor T3 have different carrier mobilities. Specifically, the carrier mobility of the first active layer A31 contacting the second source-drain electrode SD32 of the third transistor T3 can be lower than the carrier mobility of the second active layer A32 contacting the first source-drain electrode SD31 of the third transistor T3. The carrier mobility of the first active layer A31 of the third transistor T3 can also be equal to the carrier mobility of the active layer ACT1 of the first transistor T1, and the carrier mobility of the second active layer A32 of the third transistor T3 can be higher than the carrier mobility of the active layer ACT1 of the first transistor T1.

Further, the carrier mobility of the first active layer A31 of the third transistor T3 can be equal to the carrier mobility of the first active layer A21 of the active layer ACT2 in the second transistor T2, and can be lower than the carrier mobility of the second active layer A22 of the active layer ACT2 in the second transistor T2. Also, the carrier mobility of the second active layer A32 of the third transistor T3 can be higher than the carrier mobility of the first active layer A21 of the active layer ACT2 in the second transistor T2, and can be equal to the carrier mobility of the second active layer A22 of the active layer ACT2 in the second transistor T2.

The third transistor T3 can further include the third lower metal L3 beneath the active layer ACT3, and can be disposed between the third insulating layer 123 and the fourth insulating layer 124. The fourth insulating layer 124 can be disposed between the third lower metal L3 and the active layer ACT3 of the third transistor T3. The third lower metal L3 can be electrically connected to the first source-drain electrode SD31 of the third transistor T3. In this situation, the third transistor T3 can block light by virtue of the third lower metal L3, thereby minimizing the influence of light on the active layer ACT3 of the third transistor T3. Additionally, when the third lower metal L3 is electrically connected to the first source-drain electrode SD31 of the third transistor T3, the sub-threshold swing (S-factor) or the on-current value of the third transistor T3 can be enhanced.

In the display device 100 according to the present disclosure, an enhancement in S-factor can be achieved through electrical connection between the third lower metal L3 of the third transistor T3 and the first source-drain electrode SD31 of the third transistor T3. Due to the enhanced S-factor, the rate of variation of drain-source current Ids with respect to a gate voltage is small, resulting in a gradual variation in the drain-source current Ids according to gate voltage variation.

Also, the third transistor T3 can gradually vary the drain-source current Ids in response to a variation in gate voltage and, as such, can more stably and precisely control gradation representation. Accordingly, it can be possible to enhance the picture quality of the display device 100.

The third lower metal L3 can include a conductive material, and can include metals such as aluminum (Al), titanium (Ti), copper (Cu), chromium (Cr), molybdenum (Mo), and tungsten (W). The third lower metal L3 can also include a metal material different from a metal material of the gate electrode G3 of the third transistor T3. Also, the third lower metal L3 can also be disposed on a different layer from the first lower metal L1 or can include a different material from the first lower metal L1.

The thickness of the insulating layer between the active layer ACT1 and the first lower metal L1 of the first transistor T1 can be greater than the thickness of the insulating layer between the active layer ACT3 and the third lower metal L3 of the third transistor T3. Accordingly, on-current values of the first and second transistors T1 and T2 can be controlled to be different from each other.

The third lower metal L3 can be disposed on the same layer as the second lower metal L2 or can include the same material as the second lower metal L2. Also, the distance between the third lower metal L3 and the active layer ACT3 of the third transistor T3 and the distance between the second lower metal L2 and the active layer ACT2 of the second transistor T2 can be substantially equal. Accordingly, the magnitude of an electric field exerted by the third lower metal L3 on the active layer ACT3 of the third transistor T3 can be substantially equal to, or similar to, the magnitude of an electric field exerted by the second lower metal L2 on the active layer ACT2 of the second transistor T2.

In the display device 100, it can be possible to improve color coordinates and color quality by appropriately adjusting S-factors or on-current values of the second transistor T2, which is a driving transistor, and the third transistor T3 and the fourth transistor T4, which are light-emitting transistors, all being disposed at the first subpixel SP1 of the first region AA1 with the transmissive part TA. Although the second transistor T2 and the third transistor T3 have different functions, respectively, the second transistor T2 and the third transistor T3 are disposed on the same layer or formed through the same process. Accordingly, simplification of the manufacturing process can be achieved and, as such, manufacturing energy consumption can be reduced. As a result, greenhouse gas emissions generated in manufacturing processes can be reduced. Thus, environmental/social/governance (ESG) goals can be achieved.

Referring to FIG. 12, the fourth transistor T4, the fifth transistor T5, the sixth transistor T6, and the seventh transistor T7, which constitute the first subpixel SP1 disposed in the first region AA1 described with reference to FIG. 5, are disposed on the substrate 111. The fifth transistor T5, the sixth transistor T6, and the seventh transistor T7 function as switching transistors, have substantially the same structure as the first transistor T1 described with reference to FIG. 11, and are disposed on the same layer as the structures constituting the first transistor T1.

In addition, the fourth transistor T4, which functions as a light-emitting transistor, has substantially the same structure as the third transistor T3 described with reference to FIG. 11 and can be disposed on the same layer as the structures constituting the third transistor T3. Also, an active layer ACT1 constituting the fourth transistor T4 and an active layer ACT3 constituting each of the fifth transistor T5, the sixth transistor T6 and the seventh transistor T7 each includes an oxide semiconductor material. Further, the active layer ACT3 of the fourth transistor T4 functioning as a light-emitting transistor includes a first active layer A1 and a second active layer A2 having different mobilities. Since each of the active layers of the fourth transistor T4, the fifth transistor T5, the sixth transistor T6, and the seventh transistor T7 also includes an oxide semiconductor material, an upper metal CE1 can be disposed on an organic layer 140 to overlap with each of the above-described transistors.

In the display device 100 according to the present disclosure, transistors with active layers including oxide semiconductor materials, for example, the fourth transistor T4, the fifth transistor T5, the sixth transistor T6, and the seventh transistor T7, are disposed to be covered by the upper metal CE1. Accordingly, it can be possible to block light by the upper metal CE1, thereby minimizing the influence of light on the transistors.

FIG. 13 is an example of a cross-sectional view of a first subpixel of a display device according to another embodiment of the present disclosure. In association with the display device described below, redundant details overlapping with the display device described with reference to FIGs. 11 and 12 can be omitted. Components having the same reference numerals as those described with reference to FIGs. 11 and 12 can be identically applied or implemented in the other embodiment of the present disclosure, or can be applied or implemented in embodiments combined or integrated with the other embodiment.

Referring to FIG. 13, the display device 100 further includes a capacitor Cs in a first subpixel SP1 of a first area A1 having a transmissive part TA. The capacitor Cs can be disposed to overlap with a second transistor T2, which is a driving transistor, in a state of being insulated from the second transistor T2 under the condition where a third insulating layer 123, etc. are interposed between the capacitor Cs and the second transistor T2. Also, structures of first to seventh transistors T1, T2, T3, T4, T5, T6, and T7 are substantially the same as transistor structures of the embodiment described with reference to FIGs. 11 and 12, and are disposed on the same layers as the transistor structures of the embodiment described with reference to FIGs. 11 and 12. Accordingly, detailed explanations of these structures are omitted. Although the transistor structure according to the fifth embodiment described with reference to FIG. 10 is shown in FIG. 13 as the second transistor T2, the first to fourth embodiments described with reference to FIGs. 6 to 9, in addition to the fifth embodiment, can be applied to the second transistor T2.

The second capacitor Ca shown in FIG. 5 can have the same structure and can be disposed on the same layer as the first capacitor Cs. Therefore, the structure of the capacitor Cs in FIG. 13 will be described in conjunction with the first capacitor Cs shown in FIG. 5 as an example. A second capacitor Ca can be disposed to overlap with the third transistor T3 or the fourth transistor T4 shown in FIGs. 11 or 12.

The first capacitor Cs includes a first capacitor electrode C1 and a second capacitor electrode C2. The first capacitor electrode C1 can be disposed on a first insulating layer 121, and the second capacitor electrode C2 can be disposed on the first capacitor electrode C1 under the condition where a second insulating layer 122 can be interposed between the first capacitor electrode C1 and the second capacitor electrode C2.

The first capacitor electrode C1 and the second capacitor electrode C2 are disposed between the second transistor T2 and the substrate 111 to overlap with the second transistor T2. The first capacitor electrode C1 and the second capacitor electrode C2 can be disposed to overlap with the second lower metal L2 of the second transistor T2. Widths of the first and second capacitor electrodes C1 and C2 can be greater than the width of the second lower metal L2 of the second transistor T2.

The first capacitor electrode C1 can be disposed on the same layer as the first lower metal L1 of the first transistor T1. The first capacitor electrode C1 can include the same material as the first lower metal L1 of the first transistor T1. The first capacitor electrode C1 can be connected to the gate electrode G of the second transistor T2 under the condition where a plurality of insulating layers 120 is disposed therebetween. The second capacitor electrode C2 can be connected to the first source-drain electrode SD21 or the second lower metal L2 under the condition where the plurality of insulating layers 120 is disposed therebetween.

In the display device 100, it can be possible to secure a required capacitance and to increase the area and transmittance of the transmissive part TA by disposing the capacitor Cs to overlap with the second transistor T2, in addition to effects described with reference to FIG. 11. In the display device 100 according to the present disclosure, the transmissive part TA can be provided in the first area AA1, and the first subpixels SP1 are not disposed in an area occupied by the transmissive part TA. As a result, the first area AA1 can have a lower resolution than the second region AA2. In the display device 100 according to the present disclosure, however, the active layers ACT2, ACT3, and ACT4 of the second transistor T2, the third transistor T3, and the fourth transistor T4 in the first region AA1 are configured to have higher mobilities than those of the transistors in the second region AA2. Accordingly, an enhancement in luminance can be achieved through an increase in current intensity. Thus, the display device 100 according to the present disclosure can enhance the picture quality of the first area AA1 through an enhancement in luminance of the transmissive part TA.

In the display device 100, the first source-drain electrodes SD1 of the second transistor T2, the third transistor T3, and the fourth transistor T4, which are disposed in the first area AA1 with the transmissive part TA, can be connected to the lower metal LS. In this situation, accordingly, the transistors in the first area AA1 can have a greater S-factor value than the S-factor value of the second subpixel SP2 in the second area AA2. In the display device 100, it can be possible to increase S-factor values of the driving transistor and the light-emitting transistor of the first subpixel SP1 in the first area AA1 with the transmissive part TA. Accordingly, it can be possible to more stably and precisely control gradation representation.

In the display device 100, it can be possible to increase S-factor values and on-current values of the driving transistors and light-emitting transistors in the first region AA1 with the transmissive part TA. Accordingly, the first area AA1 with the transmissive part TA can exhibit light-emitting characteristics substantially equal to, or similar to, those of the second region AA2 where the transmissive part TA is not disposed. Thus, the display device 100 can match the light-emitting characteristics of the subpixels SP disposed in different areas.

As apparent from the above description, the display device 100, which employs the second transistor T2, the third transistor T3, and the fourth transistor T4 can achieve matching of light-emitting characteristics in the first area AA1 with the transmissive part TA, thereby realizing a display with high luminance. In the display device, an effective channel region can be provided for a low-mobility active layer in the active layer connected to the source-drain electrode of the transistor connected to the light-emitting element. In this situation, accordingly, it can be possible to prevent degradation of device reliability caused by a hot carrier stress phenomenon, thereby reducing defect rates.

In the transistors including active layers each including an oxide semiconductor material and the display device including the transistors, the active layers can be configured to allow the carrier mobility of the first active layer connected to the second source-drain electrode in a flow direction of current is lower than the carrier mobility of the second active layer connected to the first source-drain electrode. Accordingly, it can be possible to reduce occurrence of a hot carrier stress phenomenon in the active layer connected to the second source-drain electrode.

Additionally, in the display device according to the embodiments of the present disclosure, the transistors and the capacitors of each subpixel in the area with the transmissive part are disposed to overlap with each other. Accordingly, it can be possible to not only secure a required capacitance, but also to increase the area and transmittance of the transmissive part.

In the transistors with active layers each including an oxide semiconductor material and the display device including the transistors, most of the channel region of each active layer constituting a main channel is disposed to include a material of relatively high carrier mobility. Accordingly, it can be possible to increase current intensity, thereby enhancing luminance and improving the picture quality of the display device.

The transistors according to the embodiments of the present disclosure and the display device including the transistors can include a lower metal electrically connected to the gate electrode of the switching transistor and a lower metal electrically connected to the first source-drain electrode of the light-emitting transistor in accordance with functions of the transistors. Accordingly, it can be possible to set different values for an S-factor and on-current. The transistors can also include a lower metal connected to the first source-drain electrodes of the driving transistor and the light-emitting transistor, and an active layer with relatively high carrier mobility. Accordingly, it can be possible to achieve an enhancement in S-factor. Thus, there can be an advantage in terms of gradation representation, and the gradation representation can be stably and finely controlled. The transistors can prevent element reliability degradation, thereby reducing defect rates. It can also be possible to achieve environmental/social/governance (ESG) goals through manufacturing energy consumption according to process optimization.

The following numbered examples pertain to embodiments of the present disclosure.

Example 1: A transistor comprising: an active layer comprising an oxide semiconductor material, the active layer including a first active layer and a second active layer contacting the first active layer, the second active layer having a higher carrier mobility than a carrier mobility of the first active layer; a gate electrode overlapping at least a portion of the first active layer and at least a portion of the second active layer of the active layer to form a channel region; a first source-drain electrode insulated from the gate electrode and connected to another portion of the second active layer not overlapping the gate electrode; and a second source-drain electrode insulated from the gate electrode and connected to another portion of the first active layer not overlapping the gate electrode.

Example 2: The transistor according to Example 1, wherein the first active layer and the second active layer directly contact an upper surface of a common insulating layer in an area overlapping the gate electrode.

Example 3: The transistor according to Example 1 or 2, wherein the channel region comprises: a first channel region where the gate electrode and the first active layer overlap each other; and a second channel region where the gate electrode and the second active layer overlap each other.

Example 4: The transistor according to Example 3, wherein a length of the second channel region is greater than a length of the first channel region.

Example 5: The transistor according to Example 3 or 4, wherein at least a portion of the first channel region does not overlap with at least a portion of the second active layer.

Example 6: The transistor according to any of Examples 1 to 5, wherein a length of the second active layer overlapped by the gate electrode is greater than a length of the first active layer overlapped by the gate electrode.

Example 7: The transistor according to any of Examples 1 to 6, wherein at least a portion of the first active layer extends up to a portion of an upper surface of the second active layer to cover at least the portion of the upper surface of the second active layer.

Example 8: The transistor according to any of Examples 1 to 6, wherein at least a portion of the second active layer extends up to a portion of an upper surface of the first active layer to cover at least the portion of the upper surface of the first active layer.

Example 9: The transistor according to any of Examples 1 to 6, wherein the second active layer comprises a second lower active layer disposed beneath the first active layer, and a second upper active layer disposed on an upper surface of the first active layer, and a length of the second upper active layer of the second active layer is less than a length of the second lower active layer of the second active layer.

Example 10: The transistor according to any of Examples 1 to 6, wherein the first active layer comprises a first lower active layer disposed beneath the second active layer, and a first upper active layer disposed on an upper surface of the second active layer, and a length of the first upper active layer of the first active layer is less than a length of the first lower active layer of the first active layer.

Example 11: The transistor according to any of Examples 1 to 10, further comprising: a lower metal disposed beneath the active layer and electrically connected to the first source-drain electrode.

Example 12: The transistor according to any of Examples 1 to 11, wherein the active layer comprises a structure with the first active layer and the second active layer alternately stacked at a central portion of the channel region.

Example 13: A display device, comprising a substrate comprising a first area comprising a plurality of first subpixels and a transmissive part, and a second area comprising a plurality of second subpixels without a transmissive part; a light-emitting element at the first area; and a transistor according to any of Examples 1 to 12 connected to the light-emitting element at the first area with the transmissive part

Example 14: The display device according to Example 13, wherein the transistor is a third transistor, the display device further comprising: a first transistor disposed in the first area with the transmissive part, the first transistor comprising an active layer comprising an oxide semiconductor material, a gate electrode, and a first source-drain electrode and a second source-drain electrode; and a second transistor disposed in the first area with the transmissive part, the second transistor comprising an active layer comprising a first active layer and a second active layer each comprising an oxide semiconductor material, a gate electrode, a first source-drain electrode, and a second source-drain electrode; wherein the third transistor is electrically connected between the second transistor and the light-emitting element.

Example 15: The display device according to Example 14, wherein the second source-drain electrode of the third transistor is connected to the first active layer of the third transistor, the first active layer of the third transistor has a lower carrier mobility than the carrier mobility of the second active layer of the third transistor, and the second source-drain electrode of the third transistor is electrically connected to a first electrode of the light-emitting element.

Example 16: The display device according to Example 15, wherein a flow direction of current during operation of the third transistor proceeds toward the first electrode in an order of the first source-drain electrode of the third transistor, the second active layer of the third transistor, the first active layer of the third transistor having a lower mobility than the mobility of the second active layer of the third transistor, and the second source-drain electrode of the third transistor.

Example 17: The display device according to any of Examples 14 to 16, wherein the first transistor is a switching transistor, the second transistor is a driving transistor, and the third transistor is a light-emitting transistor.

Example 18: The display device according to any of Examples 14 to 17, wherein the active layer of the first transistor has a carrier mobility lower than or equal to the carrier mobility of the first active layer of the third transistor.

Example 19: The display device according to any of Examples 14 to 18, wherein a carrier mobility of the second active layer of the second transistor is higher than a carrier mobility of the first active layer of the second transistor, the first source-drain electrode of the second transistor is connected to the second active layer of the second transistor, and the second source-drain electrode of the second transistor is connected to the first active layer of the second transistor.

Example 20: The display device according to any of Examples 14 to 19, wherein the first transistor further comprises a first lower metal electrically connected to the gate electrode of the first transistor and disposed beneath the active layer of the first transistor, the second transistor further comprises a second lower metal electrically connected to the first source-drain electrode of the second transistor and disposed beneath the active layer of the second transistor, and the third transistor further comprises a third lower metal electrically connected to the first source-drain electrode of the third transistor and disposed beneath the active layer of the third transistor.

Example 21: The display device according to Example 20, wherein the third lower metal of the third transistor is disposed at a same layer as the second lower metal of the second transistor, and the third lower metal of the third transistor is disposed on a different layer from the first lower metal.

Example 22: The display device according to Example 20 or 21, wherein a thickness of an insulating layer between the active layer of the first transistor and the first lower metal is greater than a thickness of an insulating layer between the active layer of the second transistor and the second lower metal.

Example 23: The display device according to any of Examples 20 to 22, wherein a thickness of an insulating layer between the active layer of the first transistor and the first lower metal is greater than a thickness of an insulating layer between the active layer of the third transistor and the third lower metal.

Example 24: The display device according to any of Examples 14 to 23, further comprising: a first capacitor electrode disposed beneath the second transistor interposing an insulating layer between the first capacitor electrode and the second transistor; and a second capacitor electrode disposed between the first capacitor electrode and the second transistor, the second capacitor electrode being insulated from the first capacitor electrode, wherein the first capacitor electrode is connected to the gate electrode of the second transistor, and wherein the second capacitor electrode is connected to the first source-drain electrode of the second transistor.

Example 25: A display device comprising: a substrate comprising a first area comprising a plurality of first subpixels and a transmissive part, and a second area comprising a plurality of second subpixels without a transmissive part; a light-emitting element at the first area; and a transistor connected to the light-emitting element at the first area with the transmissive part, wherein the transistor at the first area is the transistor according to Example 1.

Example 26: A display device comprising: a substrate comprising a first area comprising a plurality of first subpixels and a transmissive part, and a second area comprising a plurality of second subpixels; a first transistor disposed in the first area with the transmissive part, the first transistor comprising an active layer comprising an oxide semiconductor material, a gate electrode, and a first source-drain electrode and a second source-drain electrode; a second transistor disposed in the first area with the transmissive part, the second transistor comprising an active layer comprising a first active layer and a second active layer each comprising an oxide semiconductor material, a gate electrode, a first source-drain electrode, and a second source-drain electrode; a light-emitting element disposed in the first area with the transmissive part; and a third transistor electrically connected between the second transistor and the light-emitting element, the third transistor comprising an active layer comprising a first active layer and a second active layer each comprising an oxide semiconductor material, a gate electrode, a first source-drain electrode, and a second source-drain electrode, wherein the second active layer of the third transistor has a higher carrier mobility than a carrier mobility of the first active layer of the third transistor.

Example 27: The display device according to Example 26, wherein the second source-drain electrode of the third transistor is connected to the first active layer of the third transistor, the first active layer of the third transistor has a lower carrier mobility than the carrier mobility of the second active layer of the third transistor, and the second source-drain electrode of the third transistor is electrically connected to a first electrode of the light-emitting element.

Example 28: The display device according to Example 27, wherein a flow direction of current during operation of the third transistor proceeds toward the first electrode in an order of the first source-drain electrode of the third transistor, the second active layer of the third transistor, the first active layer of the third transistor having a lower mobility than the mobility of the second active layer of the third transistor, and the second source-drain electrode of the third transistor.

Example 29: The display device according to any of Examples 26 to 28, wherein the first transistor is a switching transistor, the second transistor is a driving transistor, and the third transistor is a light-emitting transistor.

Example 30: The display device according to any of Examples 26 to 29, wherein the active layer of the first transistor has a carrier mobility lower than or equal to the carrier mobility of the first active layer of the third transistor.

Example 31: The display device according to any of Examples 26 to 30, wherein a carrier mobility of the second active layer of the second transistor is higher than a carrier mobility of the first active layer of the second transistor, the first source-drain electrode of the second transistor is connected to the second active layer of the second transistor, and the second source-drain electrode of the second transistor is connected to the first active layer of the second transistor.

Example 32: The display device according to any of Examples 26 to 31, wherein the first transistor further comprises a first lower metal electrically connected to the gate electrode of the first transistor and disposed beneath the active layer of the first transistor, the second transistor further comprises a second lower metal electrically connected to the first source-drain electrode of the second transistor and disposed beneath the active layer of the second transistor, and the third transistor further comprises a third lower metal electrically connected to the first source-drain electrode of the third transistor and disposed beneath the active layer of the third transistor.

Example 33: The display device according to Example 32, wherein the third lower metal of the third transistor is disposed at a same layer as the second lower metal of the second transistor, and the third lower metal of the third transistor is disposed on a different layer from the first lower metal.

Example 34: The display device according to Example 32 or 33, wherein a thickness of an insulating layer between the active layer of the first transistor and the first lower metal is greater than a thickness of an insulating layer between the active layer of the second transistor and the second lower metal.

Example 35: The display device according to any of Examples 32 to 34, wherein a thickness of an insulating layer between the active layer of the first transistor and the first lower metal is greater than a thickness of an insulating layer between the active layer of the third transistor and the third lower metal.

Example 36: The display device according to any of Examples 26 to 35, further comprising: a first capacitor electrode disposed beneath the second transistor interposing an insulating layer between the first capacitor electrode and the second transistor; and a second capacitor electrode disposed between the first capacitor electrode and the second transistor, the second capacitor electrode being insulated from the first capacitor electrode, wherein the first capacitor electrode is connected to the gate electrode of the second transistor, and wherein the second capacitor electrode is connected to the first source-drain electrode of the second transistor.

## Claims

1. A transistor (T2, T3, T4) comprising:
an active layer (ACT) comprising an oxide semiconductor material, the active layer (ACT) including a first active layer (A1) and a second active layer (A2) contacting the first active layer (A1), the second active layer (A2) having a higher carrier mobility than a carrier mobility of the first active layer (A1);
a gate electrode (G) overlapping at least a portion of the first active layer (A1) and at least a portion of the second active layer (A2) of the active layer (ACT) to form a channel region (CA);
a first source-drain electrode (SD1) insulated from the gate electrode (G) and connected to another portion of the second active layer (A2) not overlapping the gate electrode (G); and
a second source-drain electrode (SD2) insulated from the gate electrode (G) and connected to another portion of the first active layer (A1) not overlapping the gate electrode (G).

2. The transistor (T2, T3, T4) according to claim 1, wherein the first active layer (A1) and the second active layer (A2) directly contact an upper surface of a common insulating layer in an area overlapping the gate electrode (G).

3. The transistor (T2, T3, T4) according to claim 1 or 2, wherein the channel region (CA) comprises:
a first channel region (CA1) where the gate electrode (G) and the first active layer (A1) overlap each other; and
a second channel region (CA2) where the gate electrode (G) and the second active layer (A2) overlap each other.

4. The transistor (T2, T3, T4) according to claim 3, wherein a length of the second channel region (CA2) is greater than a length of the first channel region (CA1).

5. The transistor (T2, T3, T4) according to claim 3 or 4, wherein at least a portion of the first channel region (CA1) does not overlap with at least a portion of the second active layer (A2).

6. The transistor (T2, T3, T4) according to any of claims 1 to 5, wherein
a length of the second active layer (A2) overlapped by the gate electrode (G) is greater than a length of the first active layer (A1) overlapped by the gate electrode (G).

7. The transistor (T2, T3, T4) according to any of claims 1 to 6, wherein at least a portion of the first active layer (A1) extends up to a portion of an upper surface of the second active layer (A2) to cover at least the portion of the upper surface of the second active layer (A2), or
wherein at least a portion of the second active layer (A2) extends up to a portion of an upper surface of the first active layer (A1) to cover at least the portion of the upper surface of the first active layer (A1).

8. The transistor (T2, T3, T4) according to any of claims 1 to 6, wherein:
the second active layer (A2) comprises a second lower active layer (A2a) disposed beneath the first active layer (A1), and a second upper active layer (A2b) disposed on an upper surface of the first active layer (A1), and a length of the second upper active layer (A2b) of the second active layer (A2) is less than a length of the second lower active layer (A2a) of the second active layer (A2);
or wherein:
the first active layer (A1) comprises a first lower active layer (A1a) disposed beneath the second active layer (A2), and a first upper active layer (Alb) disposed on an upper surface of the second active layer (A2), and a length of the first upper active layer (A1b) of the first active layer (A1) is less than a length of the first lower active layer (A1a) of the first active layer (A1).

9. The transistor (T2, T3, T4) according to any of claims 1 to 8, further comprising:
a lower metal (LS) disposed beneath the active layer (ACT) and electrically connected to the first source-drain electrode (SD1).

10. The transistor (T2, T3, T4) according to any of claims 1 to 9, wherein the active layer (ACT) comprises a structure with the first active layer (A1) and the second active layer (A2) alternately stacked at a central portion of the channel region (CA).

11. A display device comprising:
a substrate (111) comprising a first area (AA1) comprising a plurality of first subpixels (SP1) and a transmissive part (TA), and a second area (AA2) comprising a plurality of second subpixels (SP2) without a transmissive part;
a light-emitting element (135) at the first area (AA1); and
a transistor (T3) according to any of claims 1 to 10, connected to the light-emitting element (135) at the first area (AA1) with the transmissive part (TA).

12. The display device of claim 11, wherein the transistor (T3) is a third transistor (T3), the display device further comprising:
a first transistor (T1) disposed in the first area (AA1) with the transmissive part (TA), the first transistor (T1) comprising an active layer (ACT1) comprising an oxide semiconductor material, a gate electrode (G1), and a first source-drain electrode (SD11) and a second source-drain electrode (SD12); and
a second transistor (T2) disposed in the first area (AA1) with the transmissive part (TA), the second transistor (T2) comprising an active layer (ACT2) comprising a first active layer (A21) and a second active layer (A22) each comprising an oxide semiconductor material, a gate electrode (G2), a first source-drain electrode (SD21), and a second source-drain electrode (SD22);
wherein the third transistor (T3) is electrically connected between the second transistor (T2) and the light-emitting element (135),
wherein, optionally:
the first transistor (T1) is a switching transistor,
the second transistor (T2) is a driving transistor, and
the third transistor (T3) is a light-emitting transistor.

13. The display device according to claim 12, wherein
the second source-drain electrode (SD32) of the third transistor (T3) is connected to the first active layer (A31) of the third transistor (T3), and
the second source-drain electrode (SD2) of the third transistor (T3) is electrically connected to a first electrode (E1) of the light-emitting element (135).

14. The display device according to claim 13, wherein a flow direction of current during operation of the third transistor (T3) proceeds toward the first electrode (E1) in an order of the first source-drain electrode (SD31) of the third transistor (T3), the second active layer (A32) of the third transistor (T3), the first active layer (A31) of the third transistor (T3) having a lower mobility than the mobility of the second active layer (A32) of the third transistor (T3), and the second source-drain electrode (SD32) of the third transistor (T3).

15. The display device according to any of claims 12 to 14, wherein the active layer (ACT1) of the first transistor (T1) has a carrier mobility lower than or equal to the carrier mobility of the first active layer (A31) of the third transistor (T3); and/or
wherein:
a carrier mobility of the second active layer (A22) of the second transistor (T2) is higher than a carrier mobility of the first active layer (A21) of the second transistor (T2),
the first source-drain electrode (SD21) of the second transistor (T2) is connected to the second active layer (A22) of the second transistor (T2), and
the second source-drain electrode (SD22) of the second transistor (T2) is connected to the first active layer (A21) of the second transistor (T2).
